# EUROPEAN PATENT APPLICATION

(11) **EP 3 792 266 A1**
(43) Date of publication of application: **17.03.2021**
(21) Application number: 19798827.2
(22) Date of filing: 23.04.2019
(51) Int. Cl.: C07F 5/02, C08G 61/12, C09K 11/06, G01N 30/86, G01N 30/88, H01L 51/50

(54) **COMPOUND, METHOD FOR PRODUCING COMPOUND, AND METHOD FOR PRODUCING LIGHT-EMITTING MATERIAL USING SAME**

(30) Priority: 10.05.2018 JP 2018091423
(71) Applicant: SUMITOMO CHEMICAL COMPANY LIMITED, Chuo-ku Tokyo 104-8260 (JP)
(72) Inventor: KOMATSU, Masashi, Tokyo 104-8260 (JP); KAKIMOTO, Hidenobu, Osaka-shi, Osaka 554-8558 (JP); TAKAGI, Hiroyuki, Oita-shi, Oita 870-0106 (JP)
(74) Representative: J A Kemp LLP
(86) International application number: PCT/JP2019/017134
(87) International publication number: WO 2019/216185

(57) **Abstract**

An object of the present invention is to provide a high purity raw material with which an organic EL material exhibiting high luminance, high efficiency, low voltage driving, and long lifetime can be synthesized, and a method for purifying the raw material, and a method for producing a light-emitting material synthesized using the high purity raw material, and a means for solving the problem is a compound which is a raw material for synthesizing an organic EL material, where the content of an impurity having a molecular weight larger than the molecular weight of the compound is 0.15% or less, and the content of the impurity is a percentage of the sum of peak areas having a retention time shorter than the retention of a peak identified as the compound in a chromatogram of organic solvent-based size-exclusion chromatography relative to the sum of all peak areas.

## Description

### TECHNICAL FIELD

The present invention relates to a compound, a method for producing a compound, and a method for producing a light-emitting material using the same.

### BACKGROUND ART

Materials that exhibit an organic EL phenomenon (hereinafter, referred to as "organic EL material") include light-emitting materials and electric charge transport materials. These materials all have a chemical structure in which aromatic rings are linked. As a raw material for producing an organic EL material, for example, an arylene compound represented by Formula (1) or (2) below is used.

In general, for improvement of the efficiency and lifetime of the organic EL element, the organic EL material is required to have high purity, and thus a raw material (1) or (2) to be used desirably has also high purity.

To confirm the purity of the raw material (1) or (2), analysis according to a gas chromatography method or a high performance liquid chromatography method (hereinafter referred to as "HPLC") is usually employed. Among the analysis methods, the gas chromatography method is required to keep a certain level of vapor pressure at a temperature at which a targeted substance is not decomposed, and a substance with a low vapor pressure is therefore difficult to analyze. The HPLC method enables analysis of a substance with a low vapor pressure and is often used for analysis of the raw material for an organic EL light-emitting material. For example, in JP-T-2002-536492, an aromatic monomer having a boron-containing functional group at a purity of 99% or more in the analysis according to the HPLC is synthesized.

### PRIOR ART DOCUMENT

### PATENT DOCUMENT

Patent Document 1: JP-T-2002-536492

### SUMMARY OF THE INVENTION

### PROBLEMS TO BE SOLVED BY THE INVENTION

The characteristics required for the organic EL material are, for example, high luminance, high efficiency, low voltage driving, and long lifetime of the organic EL element when the organic EL material is used for the organic EL element. However, elements produced using an organic EL material synthesized from the raw material (1) or (2) whose purity is confirmed by the HPLC method have been limited in improvement of these performances. An object of the present invention is to provide a high purity raw material (1) or (2), a method for purifying the raw material, and a method for producing a light-emitting material synthesized by using the raw material.

### MEANS FOR SOLVING THE PROBLEMS

The performance of the organic EL element is affected by the electric charge transport properties of the organic EL material used for the element. In other words, the organic EL element usually includes a plurality of layers of a light-emitting layer, a hole transport layer, a hole injection layer, an electron transport layer, and an electron injection layer, and is designed to achieve a balance between the electric charge transport properties of respective layers so as to achieve high luminance, high efficiency, low voltage driving, and long lifetime as a whole. The electric charge transport properties of the respective layers depend on the linking form of aromatic rings in the chemical structure of a compound used for the light-emitting layer. In particular, this is remarkable in the light-emitting layer. When aromatic rings having different linking forms are present in the compounds used for the respective layers, electric charge transport properties change and thus the designed balance is lost, resulting in deterioration in performance of the organic EL element. The inventor of the present invention found that the raw material (1) or (2) for the organic EL material contains, as an impurity, a compound having a different linking form of the aromatic ring.

The chemical structure of such an impurity is a structure in which aromatic rings of the raw material (1) or (2) are randomly linked, and the molecular weight of the impurity is considered to be larger than the molecular weight of a compound represented by Formula (1) or (2). Therefore, as a means for solving the problems, the content of the impurity having a molecular weight larger than the molecular weight of the compound represented by Formula (1) or (2) is limited to a specific amount or less. As a means for confirming the content of the impurity having a molecular weight larger than the molecular weight of the compound represented by Formula (1) or (2), the peak area method of organic solvent-based size-exclusion chromatography was employed.

The present invention provides a compound represented by Formula (1) or (2) below where the content of an impurity having a molecular weight larger than the molecular weight of the compound represented by Formula (1) or (2) is 0.15% or less, and the content of the impurity is a percentage of the sum of peak areas having a retention time shorter than the retention time of a peak identified as Formula (1) or (2) in a chromatogram of organic solvent-based size-exclusion chromatography relative to the sum of all peak areas.
[Chemical Formula 1]

Z¹-Ar^{Y1}-Z¹ (1)

[In the formula, Ar^{Y1} represents an arylene group, a divalent heterocyclic group, or a divalent group in which at least one arylene group and at least one divalent heterocyclic group are directly bonded, and these groups may have a substituent; and Z¹ represents a leaving group.]

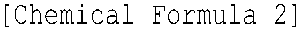

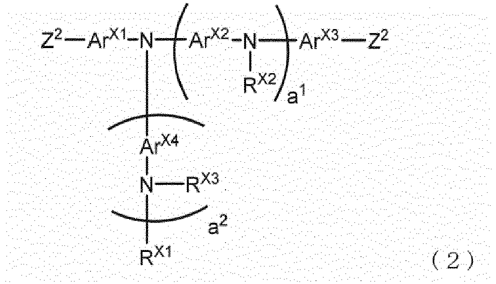

[In the formula, a¹ and a² each independently represent an integer of 0 or more; Ar^{X1} and Ar^{x3} each independently represent an arylene group or a divalent heterocyclic group, and these groups may have a substituent; Ar^{x2} and Ar^{x4} each independently represent an arylene group, a divalent heterocyclic group, or a divalent group in which at least one arylene group and at least one divalent heterocyclic group are directly bonded, and these groups may have a substituent; R^{X1}, R^{X2}, and R^{X3} each independently represent a hydrogen atom, an alkyl group, an aryl group, or a monovalent heterocyclic group, and these groups may have a substituent; and Z² represents a leaving group.]

In an embodiment, any of the compounds has a purity of more than 99% according to the area percentage method in a chromatogram of high performance liquid chromatography using a reverse-phase column.

In an embodiment, the leaving group represented by Z¹ and Z² is a group selected from the group consisting of a substituent group A or a substituent group B below.

Here, the substituent group A is a chlorine atom, a bromine atom, an iodine atom, and a group represented by - O-S(=O)₂R^{C1} (in the formula, R^{C1} represents an alkyl group or an aryl group, and these groups may have a substituent);

The substituent group B is a group represented by-B(OR^{C2} )₂ (in the formula, R^{C2} represents a hydrogen atom, an alkyl group, or an aryl group, and these groups may have a substituent; and a plurality of R^{C2} may be the same or different and may be combined together to form a ring structure together with oxygen atoms to which they are bonded);
a group represented by -BF_{3Q}' (in the formula, Q' represents Li, Na, K, Rb, or Cs);
a group represented by -MgY' (in the formula, Y' represents a chlorine atom, a bromine atom, or an iodine atom);
a group represented by -ZnY" (in the formula, Y" represents a chlorine atom, a bromine atom, or an iodine atom); and
a group represented by -Sn(R^{C3})₃ (in the formula, R^{C3} represents a hydrogen atom, an alkyl group, or an aryl group, and these groups may have a substituent; and a plurality of R^{C3} may be the same or different and may be combined together to form a ring structure together with tin atoms to which they are bonded).

In an embodiment, the leaving group represented by Z¹ and Z² represents a bromine atom or a group represented by -B (OR^{C2})₂ (in the formula, R^{C2} represents a hydrogen atom, an alkyl group, or an aryl group, and these groups may have a substituent; and a plurality of R^{C2} may be the same or different and may be combined together to form a ring structure together with oxygen atoms to which they are bonded).

In an embodiment, any of the compounds is used for synthesis of a compound by condensation reaction.

In an embodiment, the compound synthesized is an organic EL material.

In an embodiment, the compound synthesized is a polymer compound.

Further, the present invention provides a method for producing a compound, the method including performing condensation reaction by using any of the compounds represented by Formula (1) and any of the compounds represented by Formula (2).

Further, the present invention provides a method for producing a compound, the method including performing condensation reaction by using any of the compounds represented by Formula (1), any of the compounds represented by Formula (2), and a compound represented by Formula (3) below.
[Chemical Formula 3]

R^{X} 4 - Z ³ (3)

In the formula, R^{X4} represents an aryl group or a monovalent heterocyclic group, and these groups may have a substituent. Z³ represents a leaving group.

In an embodiment, the compound produced is an organic EL material.

In an embodiment, the compound produced is a polymer compound.

Further, the present invention provides a method for purifying a compound represented by Formula (1) or (2):
[Chemical Formula 4]

Z¹-Ar^{Y1}-Z¹ (1)

[In the formula, Ar^{Y1} represents an arylene group, a divalent heterocyclic group, or a divalent group in which at least one arylene group and at least one divalent heterocyclic group are directly bonded, and these groups may have a substituent; and Z¹ represents a leaving group.]

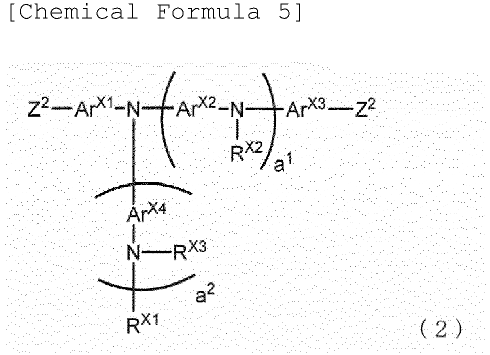

[In the formula, a¹ and a² each independently represent an integer of 0 or more; Ar^{X1} and Ar^{x3} each independently represent an arylene group or a divalent heterocyclic group, and these groups may have a substituent; Ar^{x2} and Ar^{x4} each independently represent an arylene group, a divalent heterocyclic group, or a divalent group in which at least one arylene group and at least one divalent heterocyclic group are directly bonded, and these groups may have a substituent; R^{X1}, R^{X2}, and R^{X3} each independently represent a hydrogen atom, an alkyl group, an aryl group, or a monovalent heterocyclic group, and these groups may have a substituent; and Z² represents a leaving group.]
the method including dissolving the compound represented by Formula (1) or (2) in a solvent and then bringing the compound represented by Formula (1) or (2) into contact with activated carbon to reduce the content of an impurity having a molecular weight larger than the molecular weight of the compound represented by Formula (1) or (2) to 0.15% or less, where the content of the impurity is a percentage of the sum of peak areas having a retention time shorter than the retention time of a peak identified as Formula (1) or (2) in a chromatogram of organic solvent-based size-exclusion chromatography relative to the sum of all peak areas.

Further, the present invention provides an organic EL material containing a polymer formed by condensation polymerization of any of the compounds represented by Formula (1) and any of the compounds represented by Formula (2) .

Further, the present invention provides an organic EL material containing a polymer formed by condensation polymerization of any of the compounds represented by Formula (1), any of the compounds represented by Formula (2), and the compound represented by Formula (3).

Further, the present invention provides a composition containing any of the organic EL materials and an organic solvent.

Further, the present invention provides a thin film containing any of the organic EL materials.

Further, the present invention provides an organic EL element having the thin film.

### EFFECT OF THE INVENTION

The present invention can provide a raw material for producing an organic EL material exhibiting high luminance, high efficiency, low voltage driving, and long lifetime, and a method for purifying the raw material. The present invention can also provide a method for producing an organic EL material exhibiting high luminance, high efficiency, low voltage driving, and long lifetime.

### MODE FOR CARRYING OUT THE INVENTION

### <Explanation of common terms>

Hereinafter, terms commonly used in the present specification have means shown below unless otherwise stated.

Me represents a methyl group, Et represents an ethyl group, i-Pr represents an isopropyl group, n-Bu represents an n-butyl group, and t-Bu represents a tert-butyl group.

The "polymer compound" refers to a polymer having molecular weight distribution and having a number average molecular weight of 1 × 10³ to 1 × 10⁸ in terms of polystyrene. The constitutional units contained in the polymer compound are 100 mol% in total.

The "low molecular weight compound" refers to a compound having no molecular weight distribution and having a molecular weight of 1 × 10⁴ or less.

The "constitutional unit" refers to one or more units present in a polymer compound.

The "alkyl group" may be any of straight-chain, branched, and cyclic. The number of carbon atoms of the straight-chain alkyl group does not include the number of carbon atoms of the substituent, and is usually 1 to 50, preferably 3 to 30, and more preferably 4 to 20. The number of carbon atoms of each of the branched and cyclic alkyl groups does not include the number of carbon atoms of the substituent, and is usually 3 to 50, preferably 3 to 30, and more preferably 4 to 20.

The alkyl group may have a substituent, and examples thereof include unsubstituted alkyl groups such as a methyl group, an ethyl group, an n-propyl group, an isopropyl group, an n-butyl group, an isobutyl group, a tert-butyl group, an n-pentyl group, an isoamyl group, a 2-ethyl butyl group, an n-hexyl group, a cyclohexyl group, an n-heptyl group, a cyclohexylmethyl group, a cyclohexylethyl group, an n-octyl group, a 2-ethylhexyl group, a 3-n-propylheptyl group, an n-decyl group, a 3,7-dimethyloctyl group, a 2-methyloctyl group, a 2-n-hexyl-decyl group, and an n-dodecyl group; and substituted alkyl groups such as a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-n-hexylphenyl)propyl group, and a 6-ethyloxyhexyl group.

The "aryl group" refers to a remaining atomic group in which one hydrogen atom directly bonded to a carbon atom constituting the ring is removed from the aromatic hydrocarbon. The number of carbon atoms of the aryl group does not include the number of carbon atoms of the substituent, and is usually 6 to 60, preferably 6 to 20, and more preferably 6 to 10.

The aryl group may have a substituent, and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, a 4-phenylphenyl group, and a group in which a hydrogen atom of these groups is substituted with an alkyl group, an alkoxy group, an aryl group, a fluorine atom, or the like.

The "alkoxy group" may be any of straight-chain, branched, and cyclic. The number of carbon atoms of the straight-chain alkoxy group does not include the number of carbon atoms of the substituent, and is usually 1 to 40, and preferably 4 to 10. The number of carbon atoms of each of the branched and cyclic alkoxy groups does not include the number of carbon atoms of the substituent, and is usually 3 to 40, and preferably 4 to 10.

The alkoxy group may have a substituent, and examples thereof include a methoxy group, an ethoxy group, an n-propyloxy group, an isopropyloxy group, an n-butyloxy group, an isobutyloxy group, a tert-butyloxy group, an n-pentyloxy group, an n-hexyloxy group, a cyclohexyloxy group, an n-heptyloxy group, an n-octyloxy group, a 2-ethylhexyloxy group, an n-nonyloxy group, an n-decyloxy group, a 3,7-dimethyloctyloxy group, and a lauryloxy group.

The number of carbon atoms of the "aryloxy group" does not include the number of carbon atoms of the substituent, and is usually 6 to 60, and preferably 7 to 48.

The aryloxy group may have a substituent, and examples thereof include a phenoxy group, a 1-naphthyloxy group, a 2-naphthyloxy group, a 1-anthracenyloxy group, a 9-anthracenyloxy group, a 1-pyrenyloxy group, and a group in which a hydrogen atom of these groups is substituted with an alkyl group, an alkoxy group, a fluorine atom, or the like.

The "p-valent heterocyclic group" (p represents an integer of 1 or more) refers to a remaining atomic group in which p hydrogen atoms among hydrogen atoms directly bonded to a carbon atom or heteroatom constituting the ring are removed from a heterocyclic compound. Among the p-valent heterocyclic groups, preferred is a "p-valent aromatic heterocyclic group" which is a remaining atomic group in which p hydrogen atoms among hydrogen atoms directly bonded to a carbon atom or heteroatom constituting the ring are removed from an aromatic heterocyclic compound.

The "aromatic heterocyclic compound" is a compound in which a heterocycle itself exhibits aromaticity, such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzosilole, and dibenzophosphole; and a compound in which a heterocycle itself does not exhibit aromaticity but an aromatic ring is ring-fused in the heterocycle, such as phenoxazine, phenothiazine, dibenzoborole, dibenzosilole, and benzopyran.

The number of carbon atoms of the monovalent heterocyclic group does not include the number of carbon atoms of the substituent, and is usually 2 to 60, and preferably 4 to 20.

The monovalent heterocyclic group may have a substituent, and examples thereof include a thienyl group, a pyrrolyl group, a furyl group, a pyridyl group, a piperidyl group, a quinolyl group, an isoquinolyl group, a pyrimidinyl group, a triazinyl group, and a group in which a hydrogen atom of these groups is substituted with an alkyl group, an alkoxy group, or the like.

The "halogen atom" refers to a fluorine atom, a chlorine atom, a bromine atom, or an iodine atom.

The "amino group" may have a substituent, and a substituted amino group is preferable. The substituent included in the amino group is preferably an alkyl group, an aryl group, or a monovalent heterocyclic group.

Examples of the substituted amino group include a dialkyl amino group and a diaryl amino group.

Examples of the amino group include a dimethylamino group, a diethylamino group, a diphenylamino group, a bis(4-methylphenyl)amino group, a bis(4-tert-butylphenyl)amino group, and a bis(3,5-di-tert-butylphenyl)amino group.

The "arylene group" refers to a remaining atomic group in which two hydrogen atoms directly bonded to carbon atoms constituting the ring are removed from an aromatic hydrocarbon. The number of carbon atoms of the arylene group does not include the number of carbon atoms of the substituent, and is usually 6 to 60, preferably 6 to 30, and more preferably 6 to 18.

The arylene group may have a substituent, and examples thereof include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group, and a group in which these groups have a substituent. The arylene group is preferably a group represented by Formulae (A-1) to (A-20). The arylene group contains a group in which a plurality of these groups are bonded.

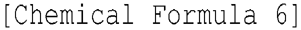

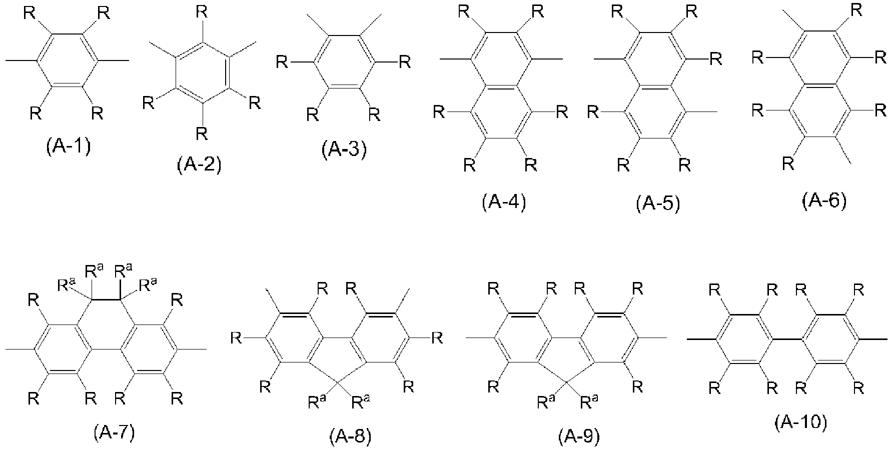

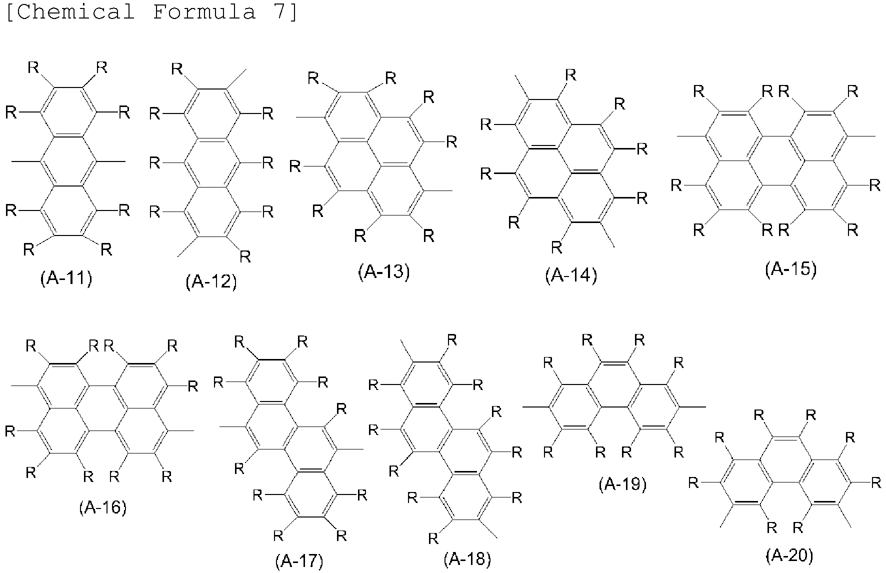

In the formula, R and R^{a} each independently represent a hydrogen atom, an alkyl group, or an aryl group. A plurality of R and R^{a} may be each the same or different. Adjacent R^{a} moieties may be bonded to each other to form a ring together with carbon atoms to which they are bonded.

The number of carbon atoms of the divalent heterocyclic group does not include the number of carbon atoms of the substituent, and is usually 2 to 60, preferably 3 to 20, and more preferably 4 to 15.

The divalent heterocyclic group may have a substituent, and examples thereof include divalent groups in which two hydrogen atoms are removed from hydrogen atoms directly bonded to a carbon atom or heteroatom constituting the ring from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole, and triazolel. The divalent heterocyclic group is preferably a group represented by Formulae (A-21) to (A-52). The divalent heterocyclic group contains a group in which a plurality of these groups are bonded.

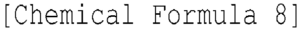

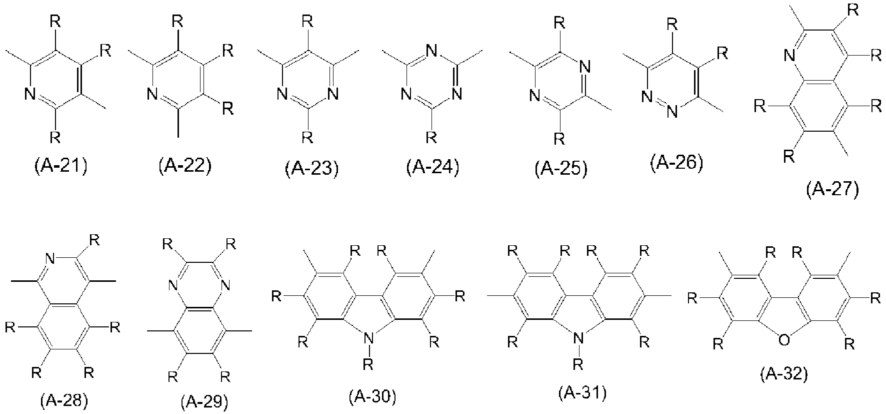

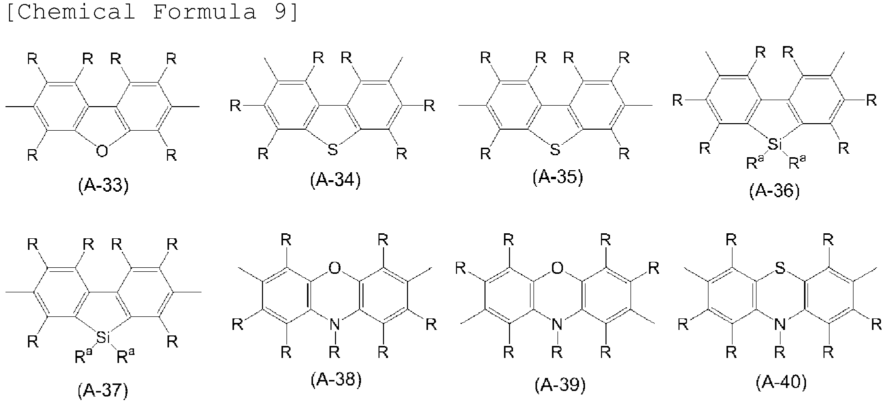

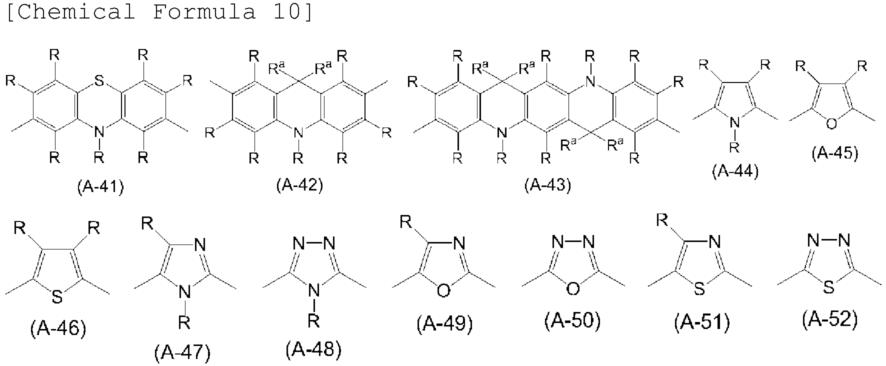

In the formula, R and R^{a} represent the same meaning as described above.

The "substituent" denotes a halogen atom, a cyano group, an alkyl group, an aryl group, a monovalent heterocyclic group, an alkoxy group, an aryloxy group, an amino group, or a substituted amino group.

The "cross-linking group" refers to a group represented by Formula (B-1), (B-2), (B-3), (B-4), (B-5), (B-6), (B-7), (B-8), (B-9), (B-10), (B-11), (B-12), (B-13), (B-14), (B-15), (B-16), or (B-17).

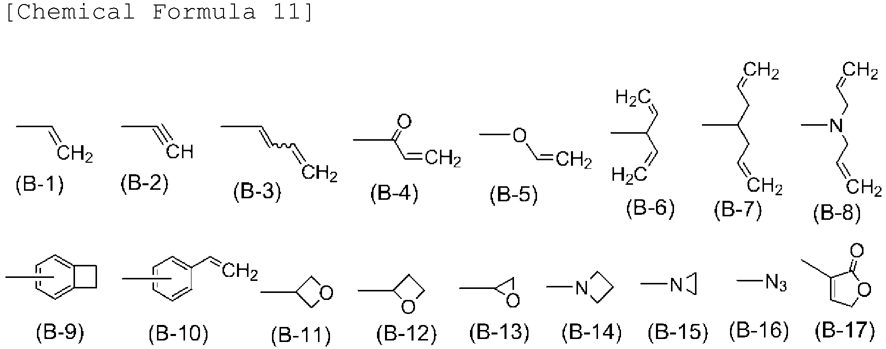

In the formula, these groups may have a substituent.

### <Polymer compound>

The polymer compound has excellent hole transport properties, and thus preferably contains a constitutional unit represented by Formula (X) below.

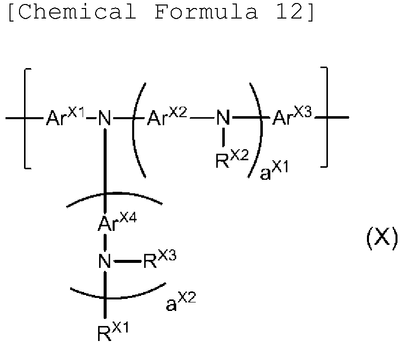

In the formula, a^{X1} and a^{X2} each independently represent an integer of 0 or more. Ar^{X1} and Ar^{x3} each independently represent an arylene group or a divalent heterocyclic group, and these groups may have a substituent; Ar^{x2} and Ar^{x4} each independently represent an arylene group, a divalent heterocyclic group, or a divalent group in which at least one arylene group and at least one divalent heterocyclic group are directly bonded, and these groups may have a substituent; R^{X1}, R^{X2}, and R^{X3} each independently represent a hydrogen atom, an alkyl group, an aryl group, or a monovalent heterocyclic group, and these groups may have a substituent; and

a^{X1} is preferably 2 or less and more preferably 1 because the luminance life of a light-emitting element produced by using the polymer compound.

a^{X2} is preferably 2 or less and more preferably 0 because the luminance life of a light-emitting element produced by using the polymer compound.

R^{X1}, R^{X2}, and R^{X3} are preferably an alkyl group, an aryl group, or a monovalent heterocyclic group, and more preferably an aryl group, and these groups may have a substituent.

The arylene group represented by Ar^{X1} and Ar^{x3} is particularly preferably a group represented by Formula (A-1) or (A-9), and especially preferably a group represented by Formula (A-1), and these groups may have a substituent.

The divalent heterocyclic group represented by Ar^{X1} and Ar^{x3} is particularly preferably a group represented by Formula (A-21), (A-22), or (A-27) to (A-46), and these groups may have a substituent.

Ar^{X1} and Ar^{x3} are preferably an arylene group that may have a substituent.

The arylene group represented by Ar^{x2} and Ar^{x4} is particularly preferably a group represented by Formula (A-1), (A-6), (A-7), (A-9) to (A-11), or (A-19), and these groups may have a substituent.

The particularly preferable range of the divalent heterocyclic group represented by Ar^{x2} and Ar^{x4} is the same as the particularly preferable range of the divalent heterocyclic group represented by Ar^{X1} and Ar^{x3}.

The particularly preferable ranges, especially preferable ranges of the arylene group and divalent heterocyclic group in a divalent group represented by Ar^{x2} and Ar^{x4} in which at least one arylene group and at least one divalent heterocyclic group are directly bonded are respectively similar to the particularly preferable ranges, especially preferable ranges of the arylene group and divalent heterocyclic group represented by Ar^{X1} and Ar^{X3}.

Examples of the divalent group represented by Ar^{x2} and Ar^{x4} in which at least one arylene group and at least one divalent heterocyclic group are directly bonded include groups represented by the following formula, and these groups may have a substituent.

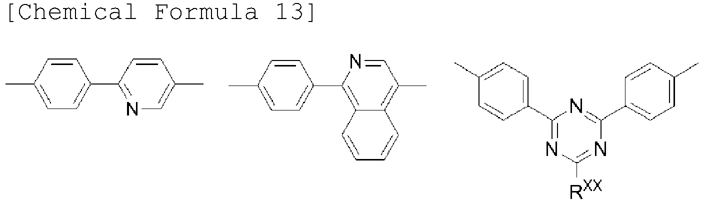

In the formula, R^{XX} represents a hydrogen atom, an alkyl group, an aryl group, or a monovalent heterocyclic group, and these groups may have a substituent.

R^{XX} is preferably an alkyl group or an aryl group, and these groups may have a substituent.

Ar^{x2} and Ar^{x4} are preferably an arylene group that may have a substituent.

Preferred examples of the substituent that may be included in the groups represented by Ar^{X1} to Ar^{x4} and R^{X1} to R^{X3} include an alkyl group or an aryl group, and these groups may further have a substituent.

The constitutional unit represented by Formula (X) is preferably a constitutional unit represented by Formulae (X-1) to (X-7), more preferably a constitutional unit represented by Formulae (X-3) to (X-7), and even more preferably a constitutional unit represented by Formulae (X-3) to (X-6).

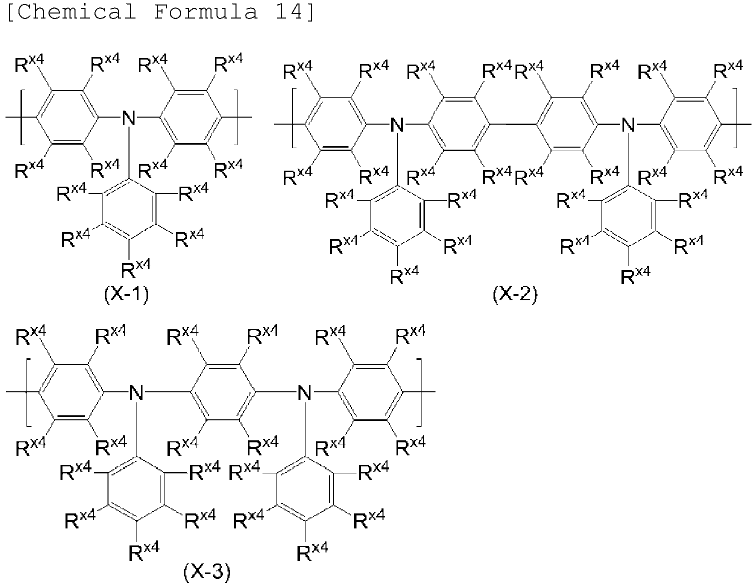

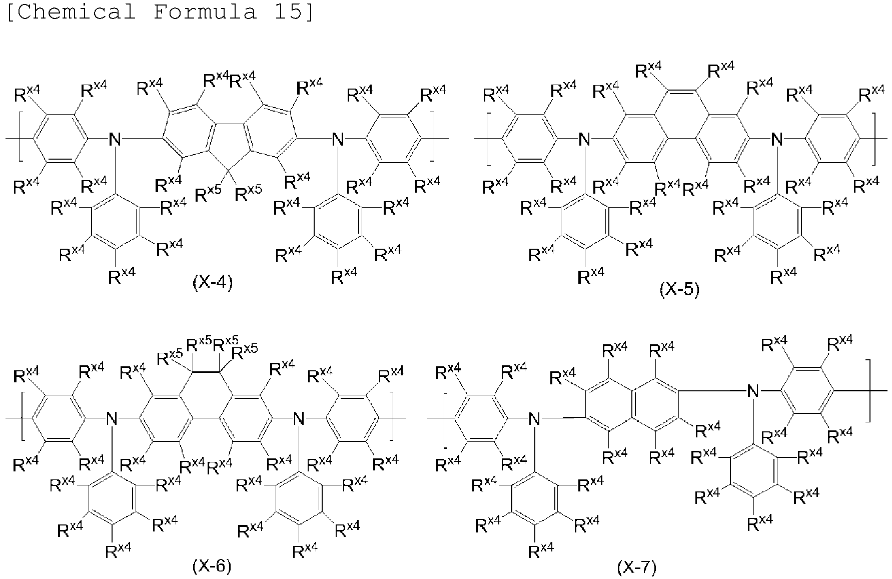

In the formula, R^{X4} and R^{x5} each independently represent a hydrogen atom, an alkyl group, an alkoxy group, an aryl group, an aryloxy group, a halogen atom, a monovalent heterocyclic group, or a cyano group, and these groups may have a substituent. A plurality of R^{X4} may be the same or different. A plurality of R^{X5} may be the same or different, adjacent R^{X5} moieties are bonded to each other to form a ring together with carbon atoms to which they are bonded.

The constitutional unit represented by Formula (X) has excellent hole transport properties, and thus is preferably 0.1 to 50 mol%, more preferably 1 to 40 mol%, and even more preferably 5 to 30 mol% relative to the total amount of the constitutional units contained in the polymer compound.

The constitutional unit represented by Formula (X) includes, for example, a constitutional unit represented by Formulae (X1-1) to (X1-19), and is preferably a constitutional unit represented by Formulae (X1-6) to (X1-14) .

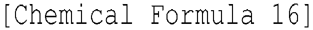

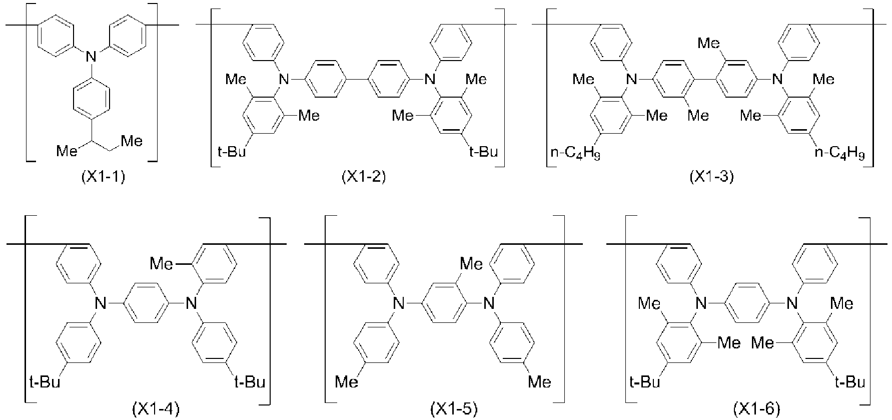

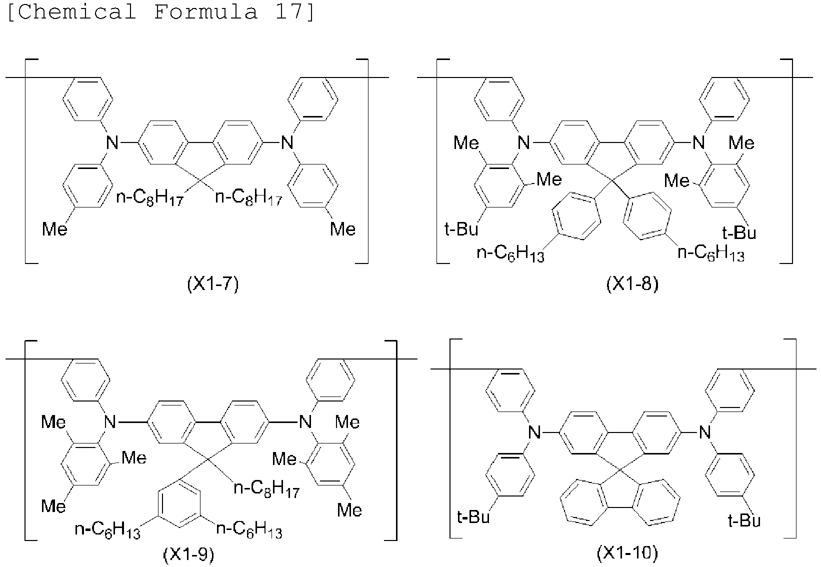

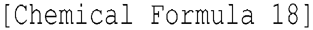

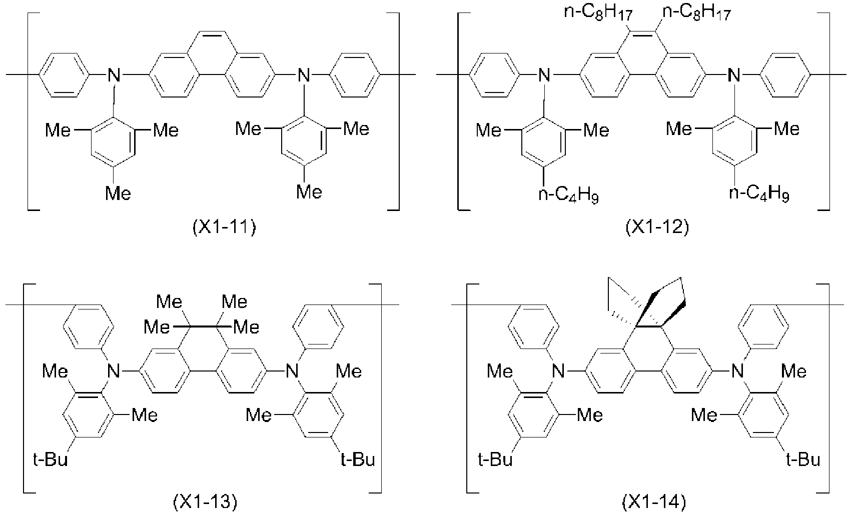

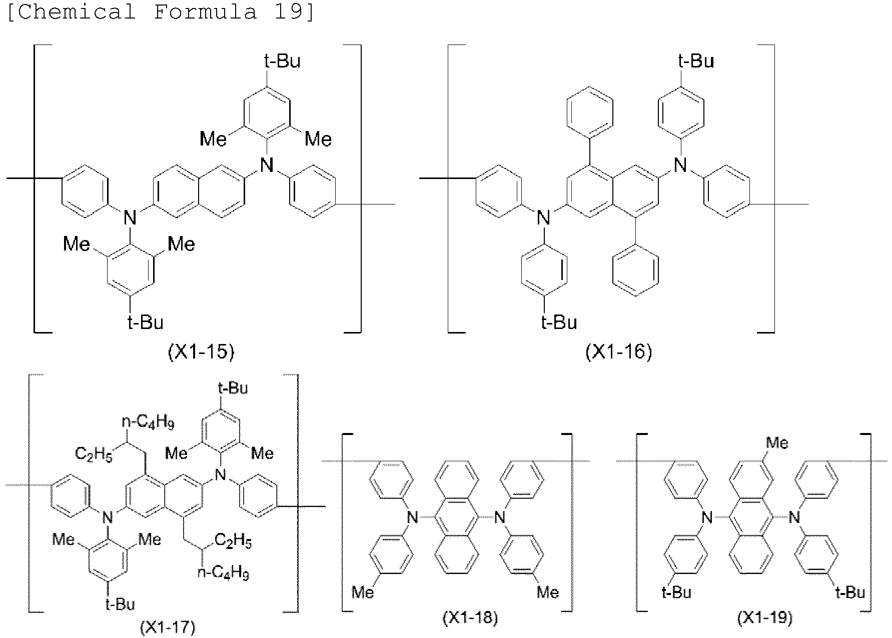

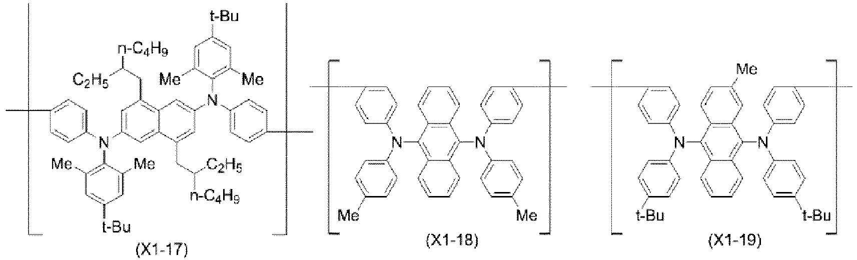

The polymer compound may contain only one type of constitutional unit represented by Formula (X), or two or more types thereof.

The polymer compound has excellent hole transport properties, and thus preferably further contains a constitutional unit represented by Formula (Y).

The polymer compound preferably contains the constitutional unit represented by Formula (X) or the constitutional unit represented by Formula (Y) in terms of luminous efficiency in the case of being used for the production of a light-emitting element.
[Chemical Formula 20]

⁅Ar^{Y1}⁆ (Y)

In the formula, Ar^{Y1} represents an arylene group, a divalent heterocyclic group, or a divalent group in which at least one arylene group and at least one divalent heterocyclic group are directly bonded, and these groups may have a substituent.

The arylene group represented by Ar^{Y1} is particularly preferably a group represented by Formula (A-1), (A-6), (A-7), (A-9) to (A-11), (A-13), or (A-19), and especially preferably a group represented by Formula (A-1), (A-7), (A-9) or (A-19), and these groups may have a substituent.

The divalent heterocyclic group represented by Ar^{Y1} is particularly preferably a group represented by Formula (A-24), (A-30), (A-33), (A-35), (A-38), or (A-40), and especially preferably a group represented by Formula (A-24), (A-30), (A-38), or (A-40), and these groups may have a substituent.

The particularly preferable ranges, especially preferable ranges of the arylene group and divalent heterocyclic group in a divalent group represented by Ar^{Y1} in which at least one arylene group and at least one divalent heterocyclic group are directly bonded are respectively similar to the particularly preferable ranges, especially preferable ranges of the arylene group and divalent heterocyclic group represented by Ar^{Y1} described above.

Preferred examples of the substituent that may be included in the group represented by Ar^{Y1} include an alkyl group or an aryl group, and these groups may further have a substituent.

Examples of the constitutional unit represented by Formula (Y) include a constitutional unit represented by Formulae (Y-1) to (Y-7). In terms of the luminance life of a light-emitting element produced by using the polymer compound, the constitutional unit is preferably a constitutional unit represented by Formula (Y-1) or (Y-2); in terms of electron transport properties, the constitutional unit is preferably a constitutional unit represented by Formula (Y-3) or (Y-4); and in terms of hole transport properties, the constitutional unit is preferably a constitutional unit represented by Formulae (Y-5) to (Y-7) .

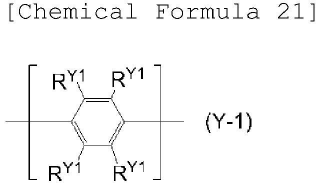

In the formula, R^{Y1} represents a hydrogen atom, an alkyl group, an alkoxy group, an aryl group, or a monovalent heterocyclic group, and these groups may have a substituent. A plurality of R^{Y1} may be the same or different, adjacent R^{Y1} moieties are bonded to each other to form a ring together with carbon atoms to which they are bonded.

R^{Y1} is preferably a hydrogen atom, an alkyl group, or an aryl group, and these groups may have a substituent.

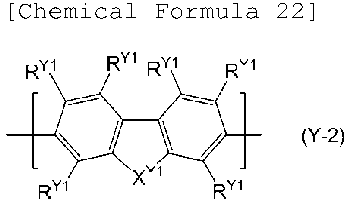

In the formula, R^{Y1} represents the same meaning as described above. X^{Y1} represents a group represented by - C (R^{Y2}) ₂-, -C (R^{Y2}) =C (R^{Y2}) -, or -C (R^{Y2})₂-C(R^{Y2})₂-. In the formula, R^{Y2} represents a hydrogen atom, an alkyl group, an alkoxy group, an aryl group, or a monovalent heterocyclic group, and these groups may have a substituent. A plurality of R^{Y2} may be the same or different, and R^{Y2} moieties are bonded to each other to form a ring together with carbon atoms to which they are bonded.

R^{Y2} is preferably an alkyl group, an aryl group, or a monovalent heterocyclic group, and more preferably an alkyl group or an aryl group, and these groups may have a substituent.

In X^{Y1}, a combination of two R^{Y2} in the group represented by -C(R^{Y2})₂- is preferably a combination in which both are alkyl groups, both are aryl groups, or both are monovalent heterocyclic groups, or a combination in which one is an alkyl group and the other is an aryl group or a monovalent heterocyclic group, more preferably, a combination in which one is an alkyl group and the other is an aryl group, and these groups may have a substituent. Two R^{Y2} may be bonded to each other to form a ring together with atoms to which they are bonded. When R^{Y2} forms a ring, the group represented by -C(R^{Y2})₂- is preferably a group represented by Formulae (Y-A1) to (Y-A5), and more preferably a group represented by Formula (Y-A4), and these groups may have a substituent.

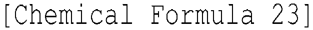

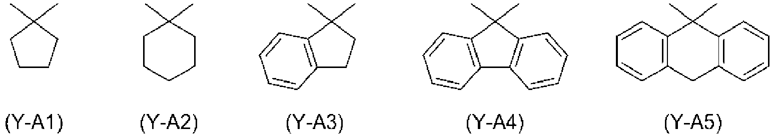

In X^{Y1}, a combination of two R^{Y2} in the group represented by -C(R^{Y2})=C(R^{Y2})- is preferably a combination in which both are alkyl groups or a combination in which one is an alkyl group and the other is an aryl group, and these groups may have a substituent.

In X^{Y1}, four R^{Y2} in the group represented by -C(R^{Y2})₂-C(R^{Y2})₂- are preferably an alkyl group that may have a substituent. A plurality of R^{Y2} may be bonded to each other to form a ring together with atoms to which they are bonded. When R^{Y2} forms a ring, the group represented by - C(R^{Y2})₂-C(R^{Y2})₂- is preferably a group represented by Formulae (Y-B1) to (Y-B5), and more preferably a group represented by Formula (Y-B3), and these groups may have a substituent.

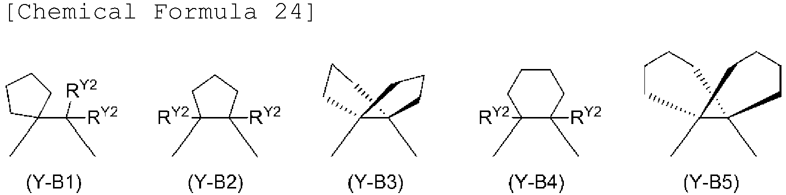

In the formula, R^{Y2} represents the same meaning as described above.

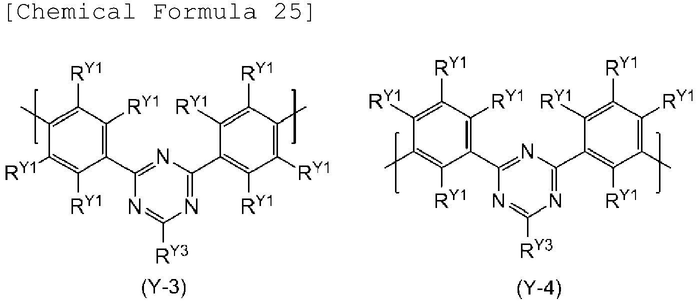

In the formula, R^{Y1} represents the same meaning as described above. In the formula, R^{Y3} represents a hydrogen atom, an alkyl group, an alkoxy group, an aryl group, or a monovalent heterocyclic group, and these groups may have a substituent.

R^{Y3} is preferably an alkyl group, an alkoxy group, an aryl group, or a monovalent heterocyclic group, and more preferably an aryl group, and these groups may have a substituent.

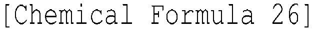

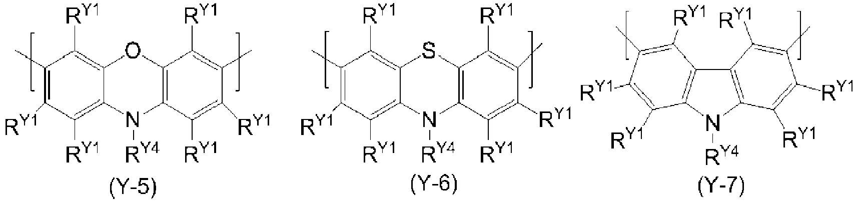

In the formula, R^{Y1} represents the same meaning as the description described above. In the formula, R^{Y4} represents a hydrogen atom, an alkyl group, an alkoxy group, an aryl group, or a monovalent heterocyclic group, and these groups may have a substituent.

RY⁴ is preferably an alkyl group, an alkoxy group, an aryl group, or a monovalent heterocyclic group, and more preferably an aryl group, and these groups may have a substituent.

Examples of the constitutional unit represented by Formula (Y) include a constitutional unit represented by Formulae (Y-11) to (Y-55).

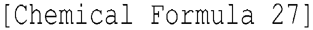

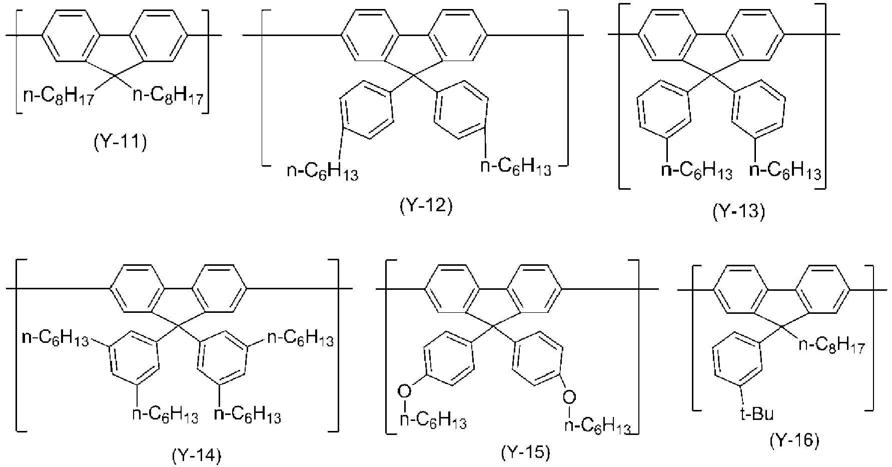

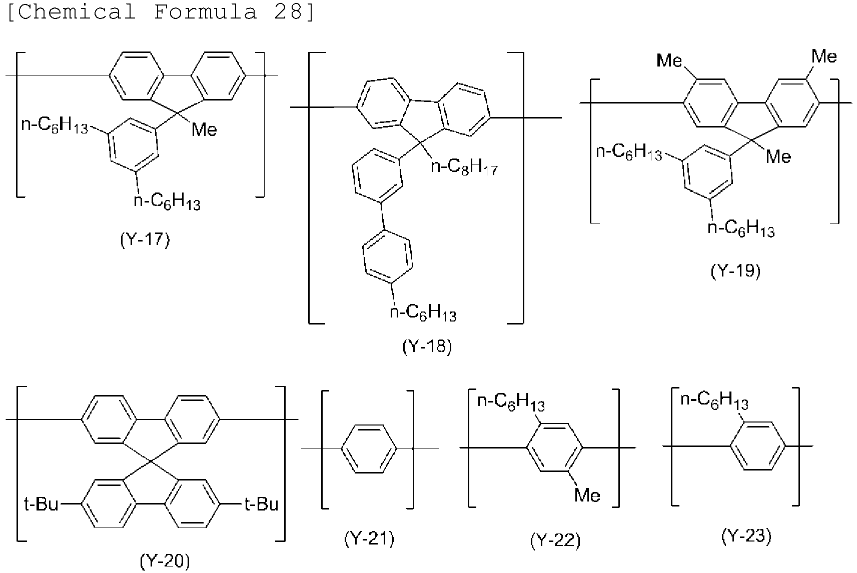

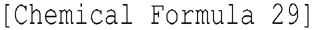

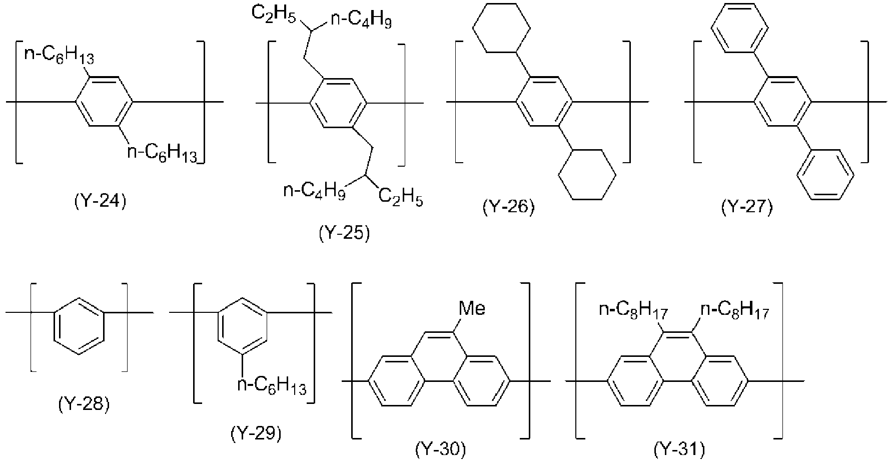

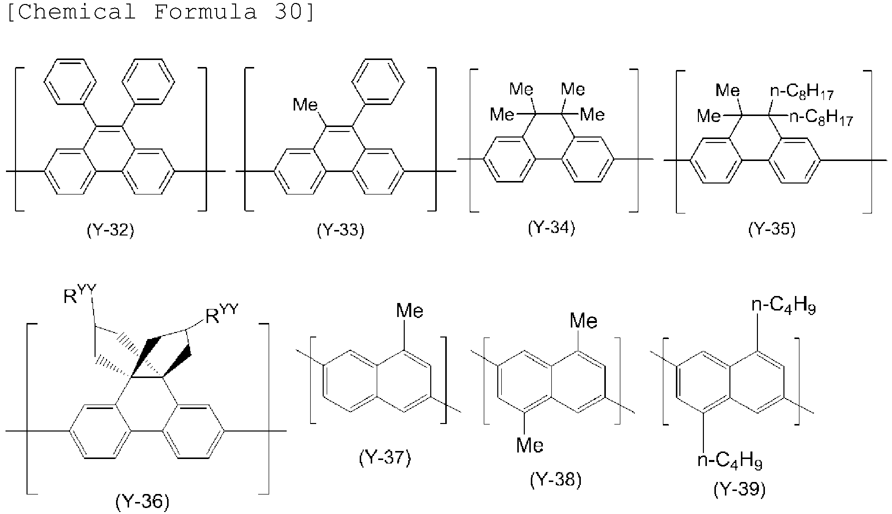

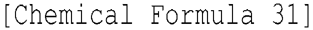

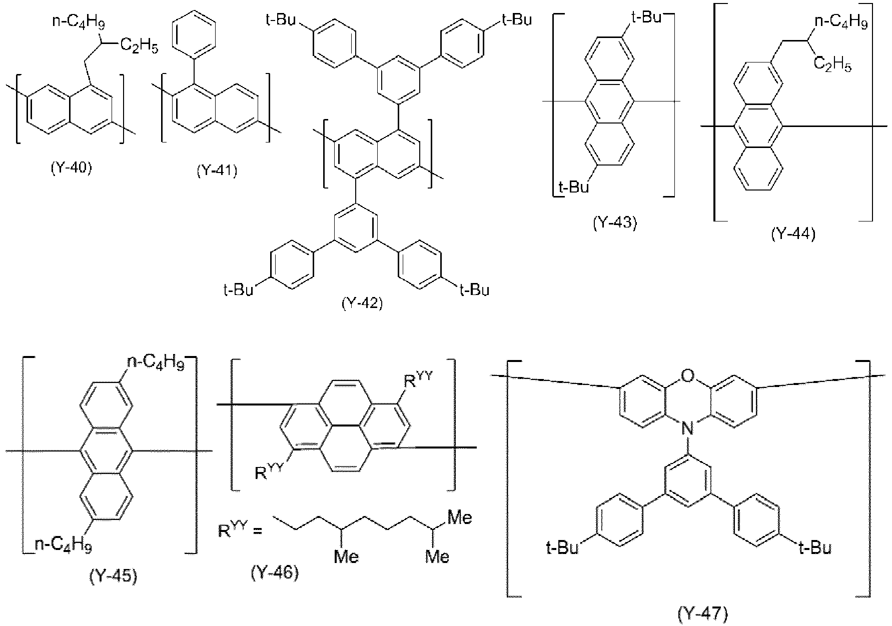

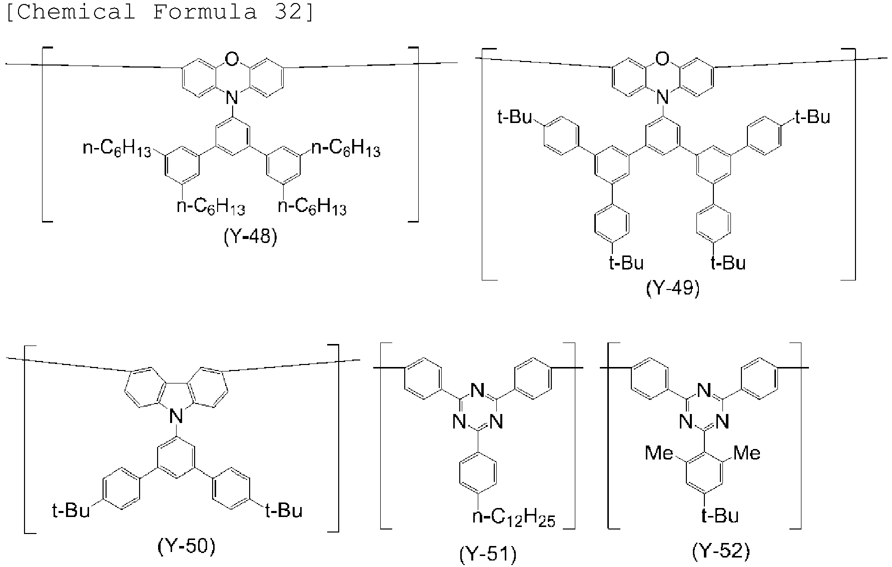

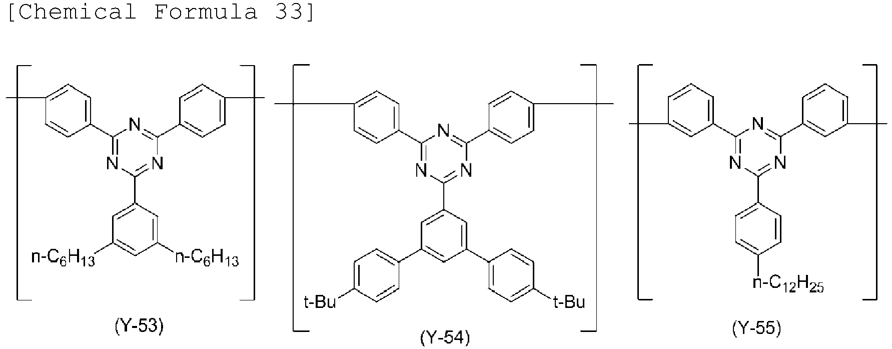

The constitutional unit represented by Formula (Y) where Ar^{Y1} is an arylene group excels in the luminance life of the light-emitting element produced by using the polymer compound. Thus, the amount of the constitutional unit is preferably 0.5 to 80 mol%, and more preferably 30 to 60 mol% relative to the total amount of the constitutional units contained in the polymer compound.

The constitutional unit represented by Formula (Y) where Ar^{Y1} is a divalent heterocyclic group or a group in which at least one arylene group and at least one divalent heterocyclic group are directly bonded excels in the electric charge transport properties of the light-emitting element produced by using the polymer compound. Thus, the amount of the constitutional unit is preferably 0.5 to 30 mol%, and more preferably 3 to 40 mol% relative to the total amount of the constitutional units contained in the polymer compound.

The polymer compound may contain only one type of constitutional unit represented by Formula (Y), or two or more types thereof.

### <High molecular weight impurity in raw material>

The raw material herein refers to a compound which becomes a raw material for synthesizing an organic EL material. The high molecular weight impurity refers to an impurity having a molecular weight larger than the molecular weight of the raw material compound. The high molecular weight impurity has a chemical structure in which aromatic rings derived from the raw material are randomly linked, and, when being present in the organic EL material, breaks the balance of electric charge transport properties in each layer in the organic EL element, and thus deteriorates performance when formed into an organic EL element. To improve the performance of the organic EL element, it is necessary to remove the high molecular weight impurity from the raw material.

The content of the high molecular weight impurity in the raw material is 0.15% or less, preferably 0.10% or less, and more preferably 0.05% or less.

The high molecular weight impurity is a component having an elution time shorter than the elution time of the compound in the analysis of the raw material compound by organic solvent-based size-exclusion chromatography. The column used for organic solvent-based size-exclusion chromatography is not particularly limited, but is preferably a column that can favorably separate substances with a molecular weight of 500 to 10,000 in terms of polystyrene in the calibration curve created using a polystyrene standard. Examples of the preferred column include TSK gel G1000 to G4000H series, GMH-L series, Super HZ1000 to 4000, and Super HZM (available from Tosoh Corporation); KF-801 to 803, 803L series, and KF-401 to 403 series (available from Shoudex); and PLGEL MIXED-A to E (available from Agilent). Further, to increase the resolution, the same or different two or more columns may be used to be arranged in series. The mobile phase in organic solvent-based size-exclusion chromatography is not particularly limited as long as the column manufacturer ensures its performance and the raw material monomer is soluble. Typically, tetrahydrofuran, chloroform, dichloromethane, dichloroethane, DMF, DMSO, dioxane, hexane, cyclohexane, NMP, methyl ethyl ketone, acetone, methanol, ethanol, or a mixed solvent thereof is used. The mobile phase is preferably tetrahydrofuran, chloroform, DMF, and acetone, and more preferably tetrahydrofuran. The detector of the chromatography is not particularly limited, and a UV-vis detector and a deferential refractive index detector are usually used, and a UV-vis detector is preferably used.

The content of the high molecular weight impurity in the raw material is determined by the following equation from a chromatogram obtained by organic solvent-based size-exclusion chromatography.

Content of high molecular weight impurity in raw material (%) = total sum of areas of components having elution time shorter than elution time of raw material monomer/total sum of areas of all eluted components

Note that peaks that are also detected in the blank analysis are excluded in calculation.

Examples of the method for synthesizing the raw material compound include the method described in JP-T-2002-536492. JP-T-2002-536492 discloses that the raw material exhibits a content of 99% or more in high performance liquid chromatography. However, the high molecular weight impurity in the raw material is not detected in the high performance liquid chromatography and thus is not sufficiently removed. The raw material needs to be purified until the high molecular weight impurity is sufficiently removed.

The raw material of the present invention preferably has a high purity as measured by high performance liquid chromatography. The purity as measured by high performance liquid chromatography is determined based on the peak area percentage of the high performance liquid chromatogram using a reverse-phase column. In the raw material of the present invention, the purity as measured by high performance liquid chromatography is more than 99%, preferably 99.5% or more, and more preferably 99.8% or more.

The type of reverse-phase column is not particularly limited as long as the raw material compound can be analyzed with high resolution, but a silica gel column is usually preferred in which an octadecyl group (C18), an octyl group (C8), a butyl group (C4), a trimethyl group (C3), a phenyl group, a cyanopropyl group, or the like is combined. Examples of the preferred column include L-column series (available from Chemicals Evaluation and Research Institute, Japan); C18M, C18P, 5C8, 5CN series (available from Shoudex); and ZORBAX RP series (available from Aglient).

As the mobile phase used for the high performance liquid chromatography using a reverse-phase column, water, methanol, acetonitrile, tetrahydrofuran, or the like is used. These substances may be mixed and used, or a gradient method which changes the mixing ratio over time may be employed. An antioxidant or a pH regulator may be added.

As the method for purifying a raw material, adsorption with an adsorbent, recrystallization, and a combination of adsorption and recrystallization are preferable.

The adsorption with an adsorbent involves dissolving a raw material monomer in an organic solvent, adding an adsorbent, heating with stirring as necessary, and then filtrating. Examples of the organic solvent include aromatic hydrocarbons such as benzene, toluene, ethylbensene, xylene, mesitylene, and 1,2,4-trimethylbenzene; halogenated aromatic hydrocarbons such as chlorobenzene, o-dichlorobenzene, m-dichlorobenzene, and bromobenzene; ethers such as diethyl ether, diisopropyl ether, and anisole; cyclic ethers such as tetrahydrofuran, and dioxane; aliphatic hydrocarbons such as pentane, hexane, heptane, and octane; halogenated hydrocarbons such as dichloromethane, dichloroethane, and chloroform; alcohols such as methanol, ethanol, and 2-propanol; ketones such as acetone, and methyl ethyl ketone; acetonitrile, dimethylformamide, dimenthylsulfoxide, and N-methylpyrrolidone, and these solvents may be mixed and used as necessary. Among them, toluene, hexane, dichloromethane, and chloroform are preferable.

The amount of the organic solvent used is usually 0.5 to 100 times by weight, and preferably 1 to 50 times by weight relative to the amount of the raw material monomer.

Examples of the adsorbent include activated carbon, silica gel, activated alumina, zeolite, activated clay, or a mixture thereof, and among them, activated carbon is preferable.

The amount of the adsorbent is usually 0.05 to 5 times by weight, and preferably 0.1 to 1 times by weight relative to the amount of the raw material monomer.

The temperature during stirring is usually from -20°C to the boiling point of the solvent, and preferably from 20°C to the boiling point of the solvent.

The stirring time is usually from 5 minutes to 48 hours, and preferably from 30 minutes to 3 hours.

The adsorbent is usually separated by filtration, but may be used in combination with a filtration aid at that time.

In the adsorption with an adsorbent, a solution of the raw material monomer may be passed through an adsorbent-packed tower, and the solution may also be circulated as necessary in this case.

The solution of the raw material monomer treated with the adsorbent is adjusted to an appropriate concentration by concentration or dilution and then may be subjected to a reaction. The crystal of the raw material monomer may be subsequently taken out by recrystallization operation.

The purification by recrystallization involves a method of heating and dissolving a raw material monomer in a soluble organic solvent, then cooling to precipitate the crystal, and separating the crystal by filtration, a method of dissolving a raw material monomer in a soluble organic solvent, then adding a poor solvent of the raw material monomer dropwise to precipitate the crystal, and separating the precipitated crystal by filtration, and a method that combines cooling and dropwise addition of a poor solvent.

Examples of the soluble organic solvent include aromatic hydrocarbons such as benzene, toluene, ethylbensene, xylene, mesitylene, and 1,2,4-trimethylbenzene; halogenated aromatic hydrocarbons such as chlorobenzene, o-dichlorobenzene, m-dichlorobenzene, and bromobenzene; ethers such as diethyl ether, diisopropyl ether, and anisole; cyclic ethers such as tetrahydrofuran, and dioxane; aliphatic hydrocarbons such as pentane, hexane, heptane, and octane; halogenated hydrocarbons such as dichloromethane, dichloroethane, and chloroform, and these solvents may be mixed and used as necessary. Among them, toluene, hexane, dichloromethane, and chloroform are preferable.

The amount of the soluble organic solvent used is usually 0.5 to 100 times by weight, and preferably 1 to 50 times by weight relative to the amount of the raw material monomer.

The poor solvent is preferably an organic solvent having a relatively high polarity, and examples thereof include alcohols such as methanol, ethanol, and 2-propanol; ketones such as acetone, and methyl ethyl ketone; acetonitrile, dimethylformamide, dimenthylsulfoxide, and N-methylpyrrolidone. These solvents may be mixed and used as necessary. Among them, methanol, ethanol, 2-propanol, acetone, and acetonitrile are preferable.

The amount of the poor solvent used is usually 0.05 to 100 times by weight, and preferably 0.1 to 50 times by weight relative to the amount of the raw material monomer.

In the case of heating and dissolving, a solvent obtained by mixing a soluble organic solvent and a poor solvent in advance can be used.

The dissolution temperature in the case of heating and dissolving is usually room temperature to the boiling point of the solvent, and preferably 30°C to the boiling point of the solvent. After dissolution of the monomer is confirmed, cooling is performed. The cooling rate is usually 2 to 50°C/hr, and preferably 5 to 30°C/hr.

To improve the effect of purification and adjust the shape of the crystal form, a seed crystal may be added during cooling, or the temperature may be raised by approximately 2 to 15°C at a stage in which the crystal precipitated, and then maintained for approximately 5 minutes to 5 hours, followed by cooling again.

Cooling is usually performed to -50°C to 80°C and preferably -20 to 30°C. After the temperature is kept at the final cooling temperature for usually 0 to 24 hours, preferably 0.5 to 8 hours, filtration is performed, and the crystal is washed with a soluble organic solvent, a poor solvent, or a mixed solvent of these solvents, followed by drying.

In the method of dissolving in a soluble organic solvent and adding a poor solvent dropwise, the poor solvent is usually added dropwise over 0.5 to 24 hours, and preferably 1 to 8 hours. The temperature during dropwise addition of the poor solvent is usually -50°C to the boiling point of the solvent, and preferably -20°C to the boiling point of the solvent.

In the case of combining heating and dissolving/cooling operation and dropwise addition of the poor solvent, the dropwise addition of the poor solvent may be performed before, during, or after the cooling operation.

After performing these purifying operations, when the high molecular weight impurity in the raw material is analyzed and the content of the high molecular weight impurity in the raw material is 0.15% or more, these purifying operations may be repeated again.

### <Method for producing polymer compound>

Next, the method for producing the polymer compound of the present invention will be described.

In the present specification, the compound used for the production of the polymer compound of the present invention may be collectively referred to as "raw material monomer".

A compound (1) or (2) is a raw material monomer in the production of the polymer compound, and Z1 and Z2 each independently represent a group selected from the group consisting of a substituent group A and a substituent group B.]

### <Substituent group A>

The substituent group A includes a chlorine atom, a bromine atom, an iodine atom, and a group represented by - O-S(=O)₂R^{C1} (in the formula, R^{C1} represents an alkyl group or an aryl group, and these groups may have a substituent).

### <Substituent group B>

The substituent group B includes a group represented by -B(OR^{C2})₂ (in the formula, R^{C2} represents a hydrogen atom, an alkyl group, or an aryl group, and these groups may have a substituent; and a plurality of R^{C2} may be the same or different and may be combined together to form a ring structure together with oxygen atoms to which they are bonded);
a group represented by -BF_{3Q}' (in the formula, Q' represents Li, Na, K, Rb, or Cs);
a group represented by -MgY' (in the formula, Y' represents a chlorine atom, a bromine atom, or an iodine atom);
a group represented by -ZnY" (in the formula, Y" represents a chlorine atom, a bromine atom, or an iodine atom); and
a group represented by -Sn(R^{C3})₃ (in the formula, R^{C3} represents a hydrogen atom, an alkyl group, or an aryl group, and these groups may have a substituent; and a plurality of R^{C3} may be the same or different and may be combined together to form a ring structure together with tin atoms to which they are bonded).

As the group represented by -B(OR^{C2})₂, the groups represented by the following formula are exemplified.

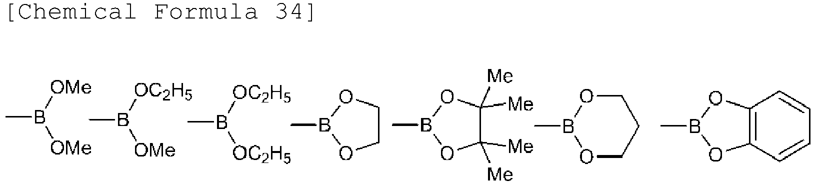

The compound having a group selected from the substituent group A and the compound having a group selected from the substituent group B undergo condensation polymerization through a publicly known coupling reaction. As a result, carbon atoms, which are bonded to the group selected from the substituent group A and the group selected from the substituent group B, are bonded to each other. Thus, when a compound having two groups selected from the substituent group A and a compound having two groups selected from the substituent group B are subjected to a publicly known coupling reaction, a condensation polymer of these compounds can be obtained by condensation polymerization.

The condensation polymerization is typically performed in the presence of a catalyst, a base, and a solvent, but may be performed in the coexistence of a phase transfer catalyst as necessary.

Examples of the catalyst include transition metal complexes including palladium complexes such as dichlorobis(triphenylphosphine)palladium, dichlorobis(tris-o-methoxyphenylphosphine) palladium, palladium[tetrakis(triphenylphosphine)], [tris(dibenzylideneacetone)]dipalladium, and palladium acetate; and nickel complexes such as nickel[tetrakis(triphenylphosphine)], [1,3-bis(diphenylphosphino)propane]dichloronickel, and [bis(1,4-cyclooctadiene)]nickel; and complexes in which these transition metal complexes further have a ligand such as triphenyl phosphine, tri-o-tolylphosphine, tri-tert-butylphosphine, tricyclohexylphosphine, diphenylphosphinopropane, and bipyridyl. The catalyst may be used singly, or in combination of two or more types.

The amount of the catalyst used is usually 0.00001 to 3 molar equivalent in terms of the amount of transition metal relative to the total molar number of the raw material monomer.

Examples of the base and phase transfer catalyst include phase transfer catalysts including inorganic bases such as sodium carbonate, potassium carbonate, cesium carbonate, potassium fluoride, cesium fluoride, and tripotassium phosphate; organic bases such as tetrabutylammonium fluoride, and tetrabutyl ammonium hydroxide; tetrabutylammonium chloride, tetrabutylammonium bromide, and tricapryl methyl ammonium chloride (Aliquat 336). The base and phase transfer catalyst may be each used singly, or in combination of two or more types.

The amounts of the base and phase transfer catalyst used are each usually 0.001 to 100 molar equivalent relative to the total molar number of the raw material monomer.

Examples of the solvent include organic solvents such as toluene, xylene, mesitylene, tetrahydrofuran, 1,4-dioxane, dimethoxyethane, N,N-dimethylacetamide, and N,N-dimethylformamide; and water. The solvent may be used singly, or in combination of two or more types.

The amount of the solvent used is usually 10 to 100,000 parts by weight relative to the total 100 parts by weight of the raw material monomer.

The reaction temperature for the condensation polymerization is usually -100 to 200°C. The reaction time for the condensation polymerization is usually 1 hour or more.

The post-treatment of the polymerization reaction is performed by using, singly or in combination, a publicly known method such as a method of removing a water-soluble impurity by liquid separation, and a method of adding a reaction solution after polymerization reaction to a lower alcohol such as methanol to cause deposition of a precipitate, and filtrating and drying the precipitate. When the purity of the polymer compound is low, purification can be performed by, for example, an ordinary method such as recrystallization, reprecipitation, continuous extraction with a Soxhlet extractor, and column chromatography.

### <Composition>

The composition contains at least one material selected from the group consisting of a hole transport material, a hole injection material, an electron transport material, an electron injection material, a light-emitting material, an antioxidant, and a solvent; and the polymer compound.

The composition containing the polymer compound and solvent (hereinafter may be referred to as "ink") is suitable for producing a light-emitting element by using a printing method such as an inkjet printing method and a nozzle printing method.

The viscosity of the ink may be controlled depending on the type of printing method. In the case of applying the ink to a printing method, in which a solution passes through an ejection apparatus, such as an inkjet printing method, the viscosity is preferably 1 to 20 mPa·s at 25°C for preventing clogging and curved flying in ejection.

The solvent contained in the ink is preferably a solvent capable of dissolving or uniformly dispersing the solid components of the ink. Examples of the solvent include chlorine solvents such as 1,2-dichloroethane, 1,1,2-trichloroethane, chlorobenzene, and o-dichlorobenzene; ether solvents such as tetrahydrofuran, dioxane, anisole, and 4-methylanisole; aromatic hydrocarbon solvents such as toluene, xylene, mesitylene, ethylbenzene, n-hexylbenzene, and cyclohexylbenzene; aliphatic hydrocarbon solvents such as cyclohexane, methylcyclohexane, n-pentane, n-hexane, n-heptane, n-octane, n-nonane, n-decane, n-decane, and bicyclohexyl; ketone solvents such as acetone, methyl ethyl ketone, cyclohexanone, benzophenone, and acetophenone; ester solvents such as ethyl acetate, butyl acetate, ethylcellosolve acetate, methyl benzoate, and phenyl acetate; polyhydric alcohol solvents such as ethylene glycol, glycerin, and 1,2-hexane diol; alcohol solvents such as isopropyl alcohol, and cyclohexanol; sulfoxide solvents such as dimethyl sulfoxide; and amide solvents such as N-methyl-2-pyrrolidone, and N,N-dimethylformamide. The solvent may be used singly, or in combination of two or more types.

The amount of the solvent blended in the ink is usually 1,000 to 100,000 parts by weight, and preferably 2,000 to 20,000 parts by weight relative to 100 parts by weight of the polymer compound.

### <Hole transport material>

The hole transport material is classified into a low molecular weight compound and a polymer compound, a polymer compound is preferable, and a polymer compound having a cross-linking group is more preferable.

Examples of the polymer compound include polyvinyl carbazole and derivatives thereof; and polyarylene having an aromatic amine structure in the side chain or main chain and derivatives thereof. The polymer compound may be a compound in which an electron accepting site is bonded. Examples of the electron accepting site include fullerene, tetrafluorotetracyanoquinodimethane, tetracyanoethylene, and trinitrofluorenone, and fullerene is preferable.

The amount of the hole transport material blended in the composition is usually 1 to 400 parts by weight, and preferably 5 to 150 parts by weight relative to 100 parts by weight of the polymer compound.

The hole transport material may be used singly, or in combination of two or more types.

### <Electron transport material>

The electron transport material is classified into a low molecular weight compound and a polymer compound. The electron transport material may have a cross-linking group.

Examples of the low molecular weight compound include a metal complex containing 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene, diphenoquinone, and derivatives thereof.

Examples of the polymer compound include polyphenylene, polyfluorene, and derivatives thereof. The polymer compound may be doped with metal.

The amount of the electron transport material blended in the composition is usually 1 to 400 parts by weight, and preferably 5 to 150 parts by weight relative to 100 parts by weight of the polymer compound.

The electron transport material may be used singly, or in combination of two or more types.

### <Hole injection material and electron injection material>

The hole injection material and electron injection material are each classified into a low molecular weight compound and a polymer compound. The hole injection material and electron injection material may have a cross-linking group.

Examples of the low molecular weight compound include metallic phthalocyanine such as copper phthalocyanine; carbon; oxides of metals such as molybdenum, and tungsten; metal fluorides such as lithium fluoride, sodium fluoride, cesium fluoride, and potassium fluoride.

Examples of the polymer compound include electrically conductive polymers such as polyaniline, polythiophene, polypyrrole, polyphenylenevinylene, polythienylenevinylene, polyquinoline and polyquinoxaline, and derivatives thereof; and polymers containing a group represented by Formula (X) in the main chain or side chain.

The amounts of the hole injection material and electron injection material blended in the composition are each usually 1 to 400 parts by weight, and preferably 5 to 150 parts by weight relative to 100 parts by weight of the polymer compound.

The hole injection material and electron injection material may be each used singly, or in combination of two or more types.

### <Ion dope>

When the hole injection material or electron injection material contains an electrically conductive polymer, the electric conductivity of the electrically conductive polymer is preferably 1 × 10⁻⁵S/cm to 1 × 10³S/cm. The electrically conductive polymer can be doped with a suitable amount of ions for adjusting the electric conductivity of the electrically conductive polymer in such a range.

The type of ion with which the hole injection material is doped is an anion, and is a cation in the case of the electron injection material. Examples of the anion include a polystyrenesulfonate ion, an alkylbenzenesulfonate ion, and a camphor sulfonate ion. Examples of the cation include a lithium ion, a sodium ion, a potassium ion, and a tetrabutyl ammonium ion.

The ions for doping may be used singly or in combination of two or more types.

### <Light-emitting material>

The polymer compound obtained by condensation reaction using the raw material compound of the present invention can be used as a light-emitting material. An issue material other than the polymer compound may be used in combination. The light-emitting material is classified into a low molecular weight compound and a polymer compound. The light-emitting material may have a cross-linking group.

Examples of the low molecular weight compound include naphthalene and derivatives thereof; anthracene and derivatives thereof; perylene and derivatives thereof; and triplet light-emitting complexes containing iridium, platinum, or europium as a center metal.

Examples of the polymer compound include polymer compounds containing a phenylene group, a naphthalenediyl group, an anthracenediyl group, a fluorenediyldiyl group, a phenanthrenediyl group, a dihydrophenanthrenediyl group, a group represented by Formula (X), a carbazolediyl group, a phenoxazinediyl group, a phenothiazinediyl group, an anthracenediyl group, and a pyrenediyl group.

The light-emitting material may contain a low molecular weight compound and a polymer compound, and preferably contains a triplet light-emitting complex and a polymer compound.

As the triplet light-emitting complex, an iridium complex such as a metal complex represented by Formulae Ir-1 to Ir-3.

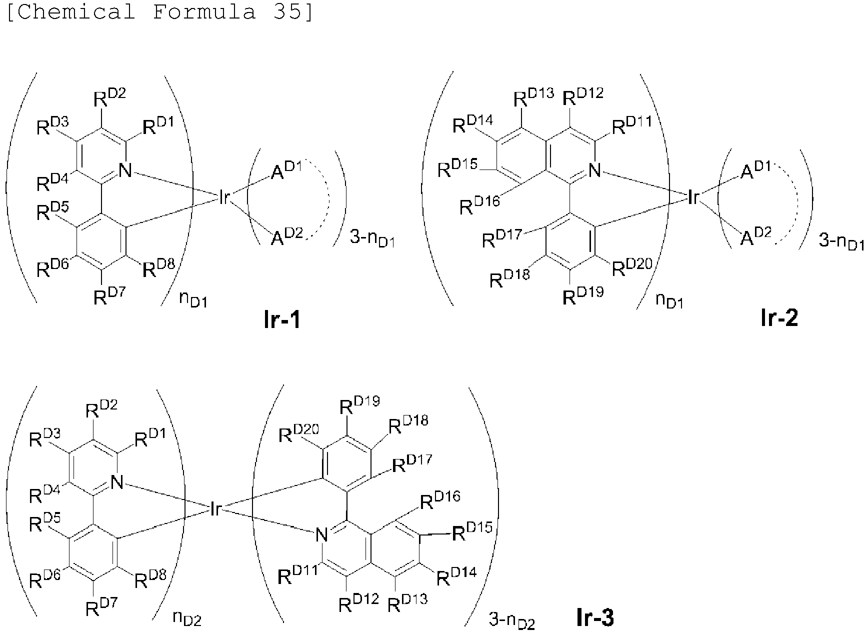

In the formula, R^{D1} to R^{D8} and R^{D11} to R^{D20} each independently represent a hydrogen atom, an alkyl group, an alkoxy group, an aryl group, an aryloxy group, a monovalent heterocyclic group, or a halogen atom, and these groups may have a substituent. -A^{D1}---A^{D2}- represents an anionic bidentate ligand, and A^{D1} and A^{D2} each independently represent a carbon atom, an oxygen atom, or a nitrogen atom which is bonded to an iridium atom. n_{D1} represents 1, 2, or 3, and n_{D2} represents 1 or 2.

In the triplet light-emitting complex represented by Formula Ir-1, at least one of R^{D1} to R^{D8} is preferably a group represented by Formula (Dend-A).

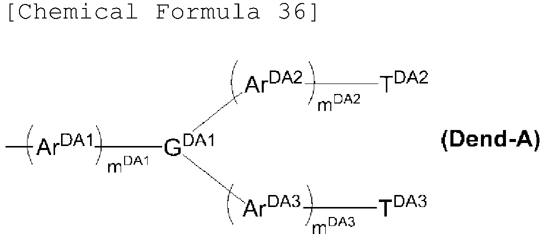

In the formula, m^{DA1}, m^{DA2}, and m^{DA3} each independently represent an integer of 0 or more. G^{DA1} represents a nitrogen atom, an aromatic hydrocarbon group, or a heterocyclic group, and these groups may have a substituent. Ar^{DA1}, Ar^{DA2}, and Ar^{DA3} each independently represent an arylene group or a divalent heterocyclic group, and these groups may have a substituent. When there are a plurality of Ar^{DA1}, Ar^{DA2}, and Ar^{DA3}, they may be the same or different. T^{DA2} and T^{DA3} each independently represent an aryl group or a monovalent heterocyclic group, and these groups may have a substituent.

m^{DA1}, m^{DA2}, and m^{DA3} are usually 10 or less. m^{DA1}, m^{DA2}, and m^{DA3} are preferably the same.

G^{DA1} is preferably a group represented by Formulae (GDA-11) to (GDA-15), and these groups may have a substituent.

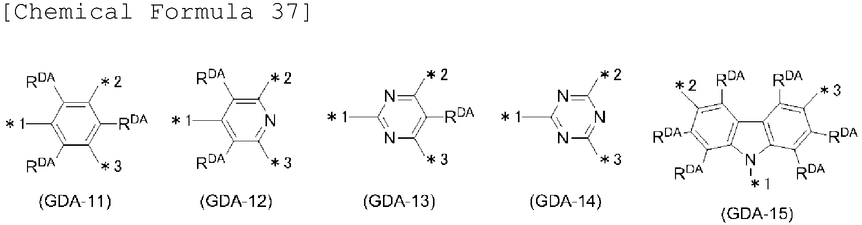

In the formula, *1, *2, and *3 each represent a bond to Ar^{DA1}, Ar^{DA2}, and Ar^{DA3}. In the formula, R^{DA} represents a hydrogen atom, an alkyl group, an alkoxy group, an aryl group, or a monovalent heterocyclic group, and these groups may further have a substituent. When there are a plurality of R^{DA}, they may be the same or different.

R^{DA} is preferably a hydrogen atom, an alkyl group, or an alkoxy group, more preferably a hydrogen atom or an alkyl group, and these groups may have a substituent.

Ar^{DA1}, Ar^{DA2}, and Ar^{DA3} are preferably a group represented by Formulae (ArDA-1) to (ArDA-3).

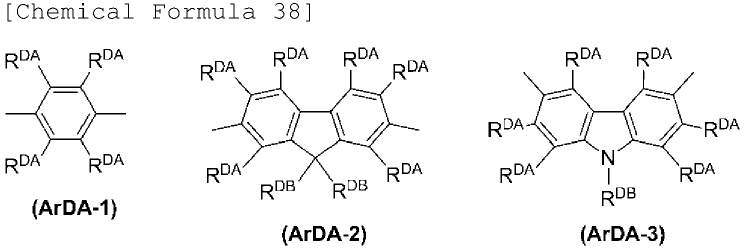

In the formula, R^{DA} represents the same meaning as described above. In the formula, R^{DB} represents a hydrogen atom, an alkyl group, an aryl group, or a monovalent heterocyclic group, and these groups may have a substituent. When there are a plurality of R^{DB}, they may be the same or different.

T^{DA2} and T^{DA3} are preferably a group represented by Formulae (TDA-1) to (TDA-3).

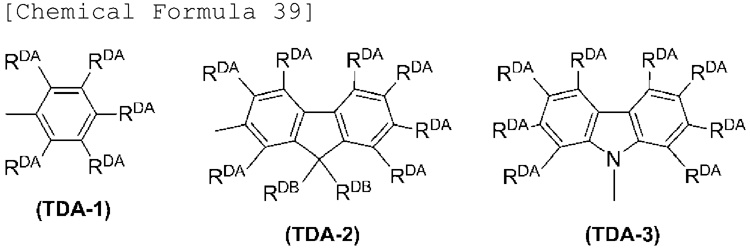

In the formula, R^{DA} and R^{DB} represent the same meaning as described above.

In Formula Ir-2, at least one of R^{D11} to R^{D20} is preferably a group represented by Formula (Dend-A).

In Formula Ir-3, at least one of R^{D1} to R^{D8} and R^{D11} to R^{D20} is preferably a group represented by Formula (Dend-A).

The group represented by Formula (Dend-A) is preferably a group represented by Formulae (Dend-A1) to (Dend-A3).

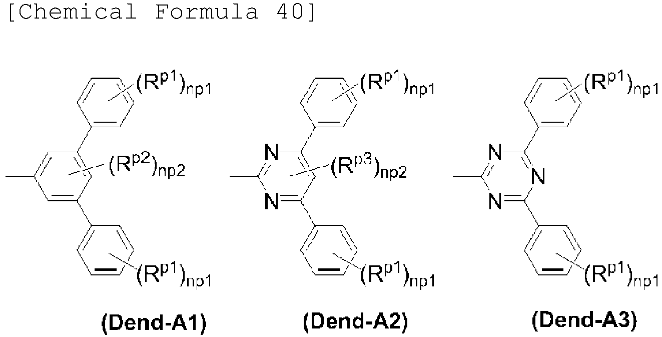

In the formula, R^{p1}, R^{p2}, and R^{p3} each independently represent an alkyl group, an alkoxy group, or a halogen atom. When there are a plurality of R^{p1} and R^{p2}, they may be the same or different. np1 represents an integer of 0 to 5, np2 represents an integer of 0 to 3, and np3 represents 0 or 1. A plurality of np1 may be the same or different.

np1 is preferably 0 or 1, and more preferably 1. np2 is preferably 0 or 1, and more preferably 0. np3 is preferably 0.

Examples of the anionic bidentate ligand represented by-A^{D1}---A^{D2}- include ligands represented by the following formula.

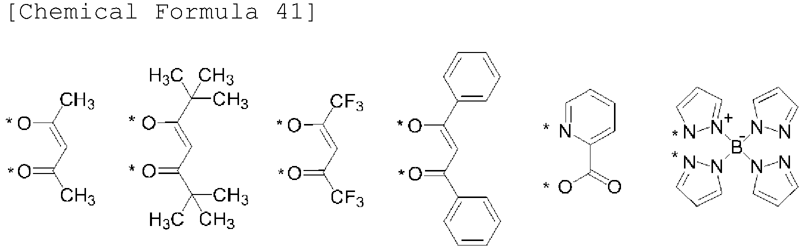

In the formula, * represents a moiety bonding to Ir.

The metal complex represented by Formula Ir-1 is preferably a metal complex represented by Formulae Ir-11 to Ir-13. The metal complex represented by Formula Ir-2 is preferably a metal complex represented by Formula Ir-21. The metal complex represented by Formula Ir-3 is preferably a metal complex represented by Formulae Ir-31 to Ir-33.

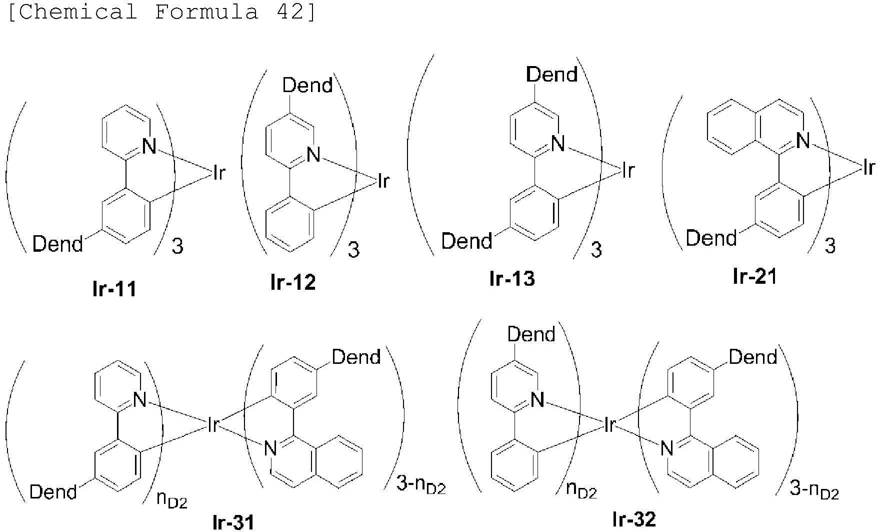

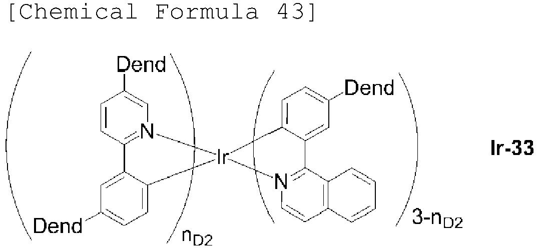

In the formula, Dend represents a group represented by Formula (Dend-A). n_{D2} represents 1 or 2.

Examples of the triplet light-emitting complex include the metal complexes shown below.

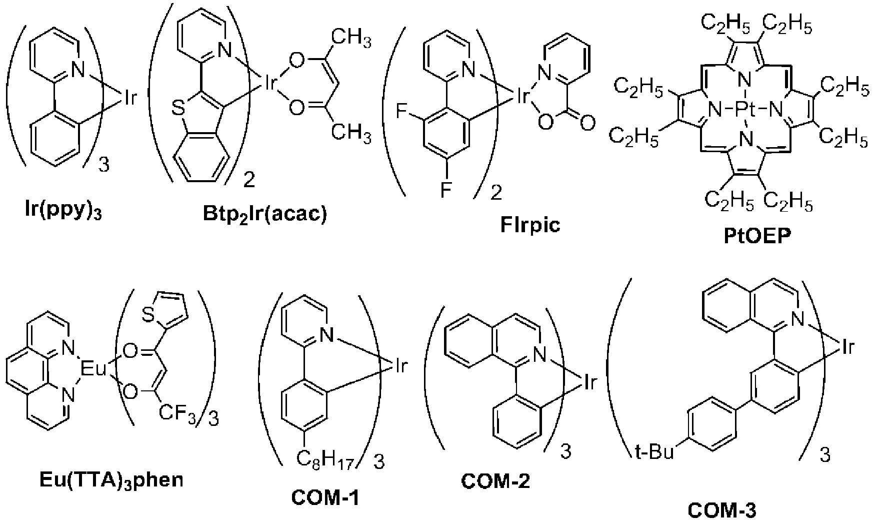

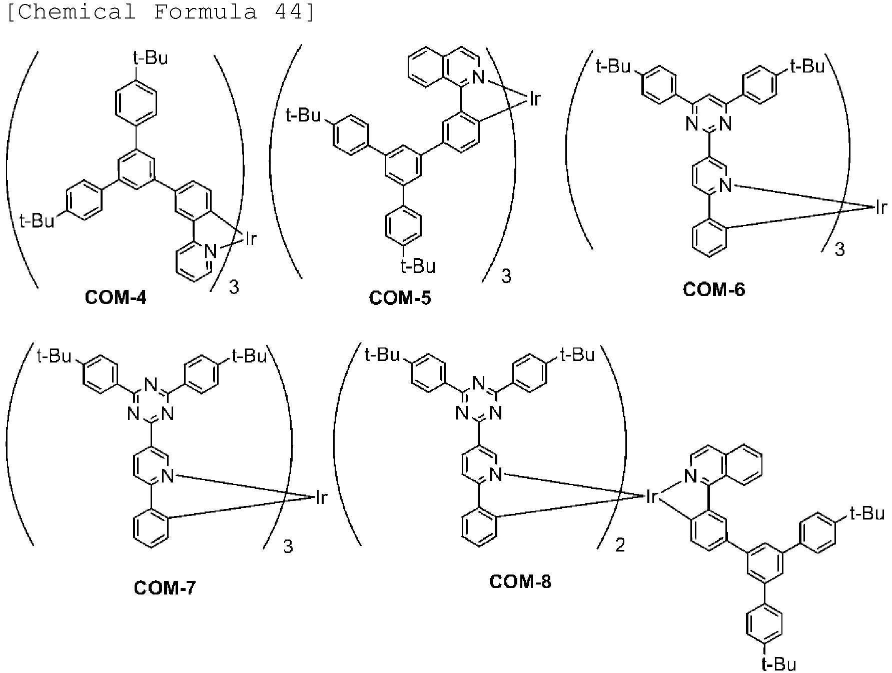

The content of the light-emitting material in the composition is usually 0.1 to 400 parts by weight relative to 100 parts by weight of the polymer compound.

### <Antioxidant>

The antioxidant may be any compound that is soluble in the same solvent as the solvent used for the polymer compound and does not inhibit light emission and electric charge transportation. Examples of the antioxidant include a phenol-based antioxidant, and a phosphorous-based antioxidant.

The amount of the antioxidant blended in the composition is usually 0.001 to 10 parts by weight relative to 100 parts by weight of the polymer compound.

The antioxidant may be used singly, or in combination of two or more types.

### <Film>

The film contains a polymer compound.

The film includes an insoluble film produced by insolubilizing a polymer compound in a solvent by crosslinking. The insoluble film is a film produced by crosslinking a polymer compound by an external stimulation such as heating and light irradiation. The insoluble film is substantially insoluble in a solvent and thus can be used suitably for lamination of a light-emitting element.

The heating temperature for crosslinking the film is usually 25 to 300°C, preferably 50 to 250°C, and more preferably 150 to 200°C because the luminous efficiency is favorable.

The types of light used for light irradiation for crosslinking the film include, for example, ultraviolet light, near-ultraviolet light, and visible light.

The film is suitable as a hole transport layer and a hole injection layer in the light-emitting element.

The film can be produced using ink by, for example, a spin coating method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method, and a nozzle coat method.

The thickness of the film is usually 1 nm to 10 µm.

### <Light-emitting element>

The light-emitting element is a light-emitting element such as an organic electroluminescence produced by using a polymer compound. Examples of the light-emitting element include a light-emitting element containing a polymer compound, and a light-emitting element in which a polymer compound is crosslinked intramolecularly, intermolecularly, or both.

The constitution of the light-emitting element include, for example, electrodes composed of an anode and a cathode, and a layer that is provided between the electrodes and obtained by using a polymer compound.

### <Layer structure>

The layer obtained by using a polymer compound is usually one or more layers of a light-emitting layer, a hole transport layer, a hole injection layer, an electron transport layer, and an electron injection layer, and is preferably a light-emitting layer. These layers respectively contain a light-emitting material, a hole transport material, a hole injection material, an electron transport material, and an electron injection material. These layers can be each formed using ink prepared by dissolving each of a light-emitting material, a hole transport material, a hole injection material, an electron transport material, and an electron injection material in the above-described solvent by a method same as the above-described method for producing a film.

The light-emitting element has the light-emitting layer between an anode and a cathode. The light-emitting element preferably has at least one layer of the hole injection layer and the hole transport layer between the anode and the light-emitting layer in terms of hole injection properties and hole transport properties, and preferably has at least one layer of the electron injection layer and the electron transport layer between the cathode and the light-emitting layer in terms of electron injection properties and electron transport properties.

Examples of the material of the hole transport layer, electron transport layer, light-emitting layer, hole injection layer, and electron injection layer include, in addition to the polymer compound, the hole transport material, electron transport material, light-emitting material, hole injection material, and electron injection material which have been respectively described above.

The materials of the hole transport layer, electron transport layer, and light-emitting layer preferably have a cross-linking group for preventing the material from being dissolved in the solvent in the case of being each dissolved in a solvent used in the formation of a layer adjacent to the hole transport layer, electron transport layer, and light-emitting layer in the production of the light-emitting element. By crosslinking the cross-linking group after forming each layer by using a material having a cross-linking group, the layer can be insolubilized.

In the case of using a low molecular weight compound, the method for forming respective layers such as the light-emitting layer, hole transport layer, electron transport layer, hole injection layer, and electron injection layer in the light-emitting element includes, for example, a vacuum vapor-deposition method using powder or a method of forming a film from a solution or melted material; and in the case of using a polymer compound, the method includes, for example, a method of forming a film from a solution or melted material.

The order, number, and thickness of the layer to be laminated may be adjusted in consideration of the luminous efficiency and lifetime of the element.

### <Substrate/electrode>

In a substrate in the light-emitting element, an electrode may be formed, and the substrate may be any substrate that does not chemically change in the formation of an organic layer. Examples of the substrate include substrates made of materials such as glass, plastic, and silicon. In the case of an opaque substrate, an electrode located furthest from the substrate is preferably transparent or semi-transparent.

Examples of the anode material include electrically conductive metal oxides and semi-transparent metals, preferably, indium oxide, zinc oxide, and tin oxide; electrically conductive compounds such as indium tin oxide (ITO), and indium zinc oxide; a complex of silver, palladium, and copper (APC); NESA, gold, platinum, silver, and copper.

Examples of the cathode material include metals such as lithium, sodium, potassium, rubidium, cesium, beryllium, magnesium, calcium, strontium, barium, aluminum, zinc, and indium; alloys composed of two or more of these metals; alloys composed of one or more of these metals and one or more of silver, copper, manganese, titanium, cobalt, nickel, tungsten, and tin; and graphite and graphite intercalation compounds. Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

The anode and cathode may each have a laminated structure of two or more layers.

### <Use>

To obtain planar light emission by using the light-emitting element, a planar anode and cathode need to be arranged so as to overlap each other. To obtain light emission with a pattern, there is a method in which a mask having a window with a pattern is provided on the surface of the planar light-emitting element, a method in which a layer to be a non-light-emitting portion is formed extremely thick so as not to substantially emit light, or a method in which either one of the anode and cathode or both electrodes are formed in a pattern. A pattern is formed by any of these methods, and some electrodes are arranged so as to be independently turned on and off, thus obtaining a segment display device that can display numbers, letters, and the like. To obtain a dot matrix display device, both the anode and cathode need to be formed in a stripe shape and arranged orthogonal to each other. A method in which a plurality of types of polymer compounds having different luminescent colors are applied, or a method in which a color filter or fluorescence conversion filter is used enables partial color display and multi-color display. The dot matrix display device can be passively driven or may be actively driven in combination with TFTs and the like. These display devices can be used for displays of computers, TV sets, and mobile terminals. The planar light-emitting element can be suitably used as a planar light source for backlight of liquid crystal display devices or a planar illumination light source. When a flexible substrate is used, use as a curved light source and a curved display device is possible.

### EXAMPLES

### <Synthesis Example 1>

In accordance with Examples of JP-T-2002-536492, 2,7-bis(1,3,2-dioxaborolane-2-yl)-9,9-dioctylfluorene (hereinafter abbreviated as F8BE) was synthesized.

The synthesized F8BE was analyzed using high performance liquid chromatography and organic solvent-based size-exclusion chromatography. The analysis condition is shown below.

High performance liquid chromatography:
Instrument: Shimadzu Corporation, LC-10AT (LC-Solution data processing)
Column: Zorbax XDB-C8 (available from Agilent)
Mobile phase: water : acetonitrile (20 : 80) constant, 1.0 mL/min
Detector: UV-Vis (280 nm)
Organic solvent-based size-exclusion chromatography
Instrument: Shimadzu Corporation, LC-10AT (LC-Solution data processing)
Column: TSKgel G2000H_{HR} (available from Tosoh Corporation)
Mobile phase: THF, 1.0 mL/min
Detector: UV-Vis (228 nm)

The content of F8BE according to a high performance liquid chromatogram was 99.8%, and the content of impurity having a retention time shorter than the retention time of F8BE in an organic solvent-based size-exclusion chromatogram was 0.16%.

### <Example 1>

### High purity F8BE

A 1 L separable flask equipped with a thermometer, a stirring blade, and a cooling tube was charged with 200 g of F8BE obtained in Synthesis Example 1 and 800 g of dichloromethane, followed by dissolving at 40°C. To this solution, 20 g of activated carbon (available from Kanto Kagaku, powder) was added, and the mixture was stirred under reflux for 2 hours. After the mixture was cooled to 30°C, the activated carbon was filtrated with a filtering apparatus pre-coated with Celite 545 (available from Kanto Kagaku) and washed with 50 g of dichloromethane. The filtrate was concentrated to 400 g by a rotary evaporator. The concentrate and 1,100 g of acetonitrile were charged in a 3 L separable flask equipped with a thermometer, a stirring blade, and a cooling tube, and the temperature was raised to 50°C. After dissolution of the crystal was confirmed, the solution was cooled to 20°C over 3 hours. After the solution was kept at 20°C for 1 hour, the purified crystal was filtrated, washed with acetonitrile, and dried by a vacuum dryer at 50°C to obtain 160 g of high purity F8BE.

The content of F8BE according to a high performance liquid chromatogram was 100%, and the content of impurity having a retention time shorter than the retention time of F8BE in an organic solvent-based size-exclusion chromatograph chromatogram was 0.09%.

### <Example 2>

### High purity F8BE

A 1 L jacketed separable flask equipped with a thermometer, a Pfaudler type impeller, a finger baffle, and a cooling tube was charged with 200 g of F8BE obtained in Synthesis Example 1 and 750 g of hexane. Hot water was circulated in the jacket of the separable flask by using a hot water circulator equipped with a program temperature regulator. The temperature was raised with the jacket temperature at 60°C. After dissolution of the crystal was confirmed, the number of stirring revolutions was set to 500 rpm, and the solution was cooled to 40°C at a cooling rate of 10°C/hr. Then, 0.05 g of high purity F8BE obtained in Example 1 was added as a seed crystal, and the resulting solution was kept at 40°C for 1 hour. The solution was cooled to 0°C at a cooling rate of 10°C/hr, and then kept at 0°C for 1 hour. The precipitated crystal was filtrated and washed with 100 g of hexane cooled to 5°C, and then dried by a vacuum dryer at 50°C to obtain 180 g of high purity F8BE.

The content of F8BE according to a high performance liquid chromatogram was 99.9%, and the content of impurity having a retention time shorter than the retention time of F8BE in an organic solvent-based size-exclusion chromatogram was 0.06%.

### <Synthesis Example 2>

In accordance with Examples of JP-T-2002-536492, 2,7-bis(1,3,2-dioxaborolane-2-yl)-9,9-dihexylfluorene (hereinafter abbreviated as F6BE) was synthesized.

The content of F6BE according to a high performance liquid chromatogram was 99.9%, and the content of impurity having a retention time shorter than the retention time of F6BE in an organic solvent-based size-exclusion chromatogram was 0.23%.

### <Example 3>

### High purity F6BE

A 1 L jacketed separable flask equipped with a thermometer, a Pfaudler type impeller, a finger baffle, and a cooling tube was charged with 300 g of F6BE obtained in Synthesis Example 2 and 450 g of toluene. Hot water was circulated in the jacket of the separable flask by using a hot water circulator equipped with a program temperature regulator. The temperature was raised with the jacket temperature at 80°C. After dissolution of the crystal was confirmed, the number of stirring revolutions was set to 450 rpm, and the solution was cooled to 60°C at a cooling rate of 10°C/hr. Then, 0.15 g of F6BE obtained in Synthesis Example 2 was added as a seed crystal, and the resulting solution was kept at 60°C for 1 hour. The solution was cooled to 0°C at a cooling rate of 10°C/hr, and then kept at 0°C for 1 hour. The precipitated crystal was filtrated and washed with 30 g of toluene and 150 g of hexane cooled to 5°C, and then dried by a vacuum dryer at 50°C to obtain 240 g of high purity F6BE.

The content of F6BE according to a high performance liquid chromatogram was 99.9%, and the content of impurity having a retention time shorter than the retention time of F6BE in an organic solvent-based size-exclusion chromatogram was 0.04%.

### <Example 4>

A separable flask equipped with a stirring blade, a baffle, a cooling tube, and a thermometer was charged with 3.30 g of F8BE obtained in Example 1, 1.68 g of 2,7-dibromo-2,1,3-benzothiadiazole, 0.56 g of 4,7-bis(5-bromo-2-thienyl)-2,1,3-benzothiadiazole, 1.1 g of tricaprylmethylammonium chloride (Aliquat 336), and 48.6 g of toluene, and the temperature was raised to 90°C with stirring. Then, 0.005 g of bis(triphenylphosphine)palladium(II) dichloride was charged, and 13 g of 17.5% sodium carbonate aqueous solution was added dropwise. After completion of the dropwise addition, the temperature of the solution was kept under reflux for 3 hours and then cooled to room temperature.

To the reaction solution, 7.88 g of F6BE obtained in Example 3, 4.49 g of 2,7-dibromo-9,9-dihexylfluorene, 3.05 g of bis-(4-bromophenyl)-4-(1-methylpropyl)-benzeneamine, 0.108 g of 3,7-dibromo-10-(4-butylphenyl)-10H-phenoxazine, 2.0 g of tricaprylmethylammonium chloride (Aliquat 336), and 78.1 g of toluene were added, and the temperature was raised to 90°C with stirring. Then, 0.005 g of bis(triphenylphosphine)palladium(II) dichloride was charged, and 39 g of 17.5% sodium carbonate aqueous solution was added dropwise. After completion of the dropwise addition, the temperature of the solution was kept under reflux for 3 hours, and then 0.28 g of phenylboronic acid was added. Then, the temperature of the resulting solution was kept under reflux for 14 hours and cooled to room temperature.

The reaction solution was transferred to a separable flask with a cock without a bottom, diluted with toluene, and allowed to stand, and then an aqueous layer was removed. The toluene solution was washed with a 3% acetic acid aqueous solution and ion exchanged water. Then, 2.3 g of sodium N,N-diethyldithiocarbamate trihydrate was added to the solution, followed by stirring for 5 hours.

The toluene solution was allowed to pass through a column including 142 g of silica gel and 142 g of activated alumina mixed in advance, after which the resulting solution was added dropwise to 1,600 g of methanol. The produced red precipitate was filtrated, washed with methanol, and dried under reduced pressure to obtain 10 g of red polymer.

The weight average molecular weight in terms of polystyrene of the resulting red polymer according to the organic solvent-based size-exclusion chromatographic analytical method was 469,000.

### <Comparative Example 1>

The same procedure as that used in Example 4 was performed except that, in Example 4, F8BE obtained in Synthesis Example 1 was used in place of F8BE obtained in Example 1, and F6BE obtained in Synthesis Example 2 was used in place of F6BE obtained in Example 3, thus obtaining 10 g of polymer.

The weight average molecular weight in terms of polystyrene of the resulting red polymer according to the organic solvent-based size-exclusion chromatographic analytical method was 511,000.

### <Synthesis Example 3>

A separable flask equipped with a stirring blade, a baffle, a cooling tube, and a thermometer was charged with 10.49 g of F8BE obtained in Synthesis Example 1 and 9.07 g of bis-(4-bromophenyl)-4-(1-methylpropyl)-benzeneamine, and then charged with 1.8 g of tricaprylmethylammonium chloride (Aliquat 336) and 120 g of toluene, and the reaction solution was heated to 90°C with stirring. Then, 0.0044 g of palladium acetate (II) and 0.030 g of tri(o-tolyl)phosphine were added, after which 36.3 g of 17.5% sodium carbonate aqueous solution was added dropwise over 1 hour. After completion of the dropwise addition, the temperature of the solution was kept under reflux for 3 hours, and then 0.28 g of phenylboronic acid was added. Then, the temperature of the resulting solution was kept under reflux for 14 hours and cooled to room temperature.

The following operation was performed in the same manner as in Example 4. The weight average molecular weight in terms of polystyrene of the resulting polymer according to the organic solvent-based size-exclusion chromatographic analytical method was 289,000.

### <Example 5>

A glass substrate, which has been coated with an ITO film with a thickness of 150 nm by a sputtering method, was coated with a suspension of poly(3,4)ethylenedioxythiophene/polystyrene sulfonic acid (available from Bayer) by a spin coating method to form a film with a thickness of approximately 65 nm, and the substrate was dried on a hot plate at 200°C for 15 minutes. Subsequently, the polymer obtained in Synthesis Example 3 was dissolved in mixed xylene at a concentration of 0.5 % by weight, and a film with a thickness of approximately 10 nm was formed using the resulting xylene solution by a spin coating method. Then, the film was dried at 180°C for 15 minutes in a nitrogen atmosphere where the oxygen concentration and moisture concentration were 10 ppm or less (on weight basis). Next, the polymer obtained in Example 4 was dissolved in mixed xylene at a concentration of 1.6 % by weight, and a film with a thickness of approximately 100 nm was formed using the resulting xylene solution by a spin coating method. Then, the film was dried at 130°C for 30 minutes in a nitrogen atmosphere where the oxygen concentration and moisture concentration were 10 ppm or less (on weight basis). After the pressure was reduced to 1.0 × 10⁻⁴ Pa or less, as a cathode, barium was vapor-deposited with a thickness of approximately 5 nm, and then aluminum was vapor-deposited with a thickness of approximately 80 nm. After the vapor-deposition, sealing was performed using a glass substrate to produce a polymer light-emitting element. The element structure was as follows.

ITO/BaytronP(approximately 65 nm)/polymer of Synthesis Example 3 (10 nm)/polymer of Example 4 (approximately 100 nm)/Ba/Al

When a voltage of 6.0 V was applied to the resulting polymer light-emitting element, fluorescence with a peak top of emission wavelength of 645 nm was emitted, and the luminance at that time was 1,261 cd/m². Also, the luminous efficiency showed the maximum value at 4.2 V, and was 2.05 cd/A. Further, the decrease time (lifetime) until luminance 50% at an initial luminance of 3,000 cd/m² was 187.8 hours. The initial drive voltage was 6.6 V.

### <Comparative Example 2>

A glass substrate, which has been coated with an ITO film with a thickness of 150 nm by a sputtering method, was coated with a suspension of poly(3,4)ethylenedioxythiophene/polystyrene sulfonic acid (available from Bayer) by a spin coating method to form a film with a thickness of approximately 65 nm, and the substrate was dried on a hot plate at 200°C for 15 minutes. Subsequently, the polymer obtained in Synthesis Example 3 was dissolved in mixed xylene at a concentration of 0.5 % by weight, and a film with a thickness of approximately 10 nm was formed using the resulting xylene solution by a spin coating method. Then, the film was dried at 180°C for 15 minutes in a nitrogen atmosphere where the oxygen concentration and moisture concentration were 10 ppm or less (on weight basis). Next, the polymer obtained in Comparative Example 1 was dissolved in mixed xylene at a concentration of 1.6 % by weight, and a film with a thickness of approximately 100 nm was formed using the resulting xylene solution by a spin coating method. Then, the film was dried at 130°C for 30 minutes in a nitrogen atmosphere where the oxygen concentration and moisture concentration were 10 ppm or less (on weight basis). After the pressure was reduced to 1.0 × 10⁻⁴ Pa or less, as a cathode, barium was vapor-deposited with a thickness of approximately 5 nm, and then aluminum was vapor-deposited with a thickness of approximately 80 nm. After the vapor-deposition, sealing was performed using a glass substrate to produce a polymer light-emitting element. The element structure was as follows.

ITO/BaytronP(approximately 65 nm)/polymer of Synthesis Example 3 (10 nm)/polymer of Comparative Example 1 (approximately 100 nm)/Ba/Al

When a voltage of 6.0 V was applied to the resulting polymer light-emitting element, fluorescence with a peak top of emission wavelength of 645 nm was emitted, and the luminance at this time was 995 cd/m². Also, the luminous efficiency showed the maximum value at 5.0 V, and was 1.94 cd/A. Further, the decrease time (lifetime) until luminance 50% at an initial luminance of 3,000 cd/m² was 133.6 hours. The initial drive voltage was 7.2 V.

The summarize of the comparison of the elements obtained in Example 5 and Comparative Example 2 is as follows.

**[Table 1]**

| | Example 5 | Comparative Example 2 |
|---|---|---|
| Element constitution | ITO/BaytronP (approximately 65 nm)/polymer of Synthesis Example 3 (10 nm)/polymer of Example 4 (approximately 100 nm)/Ba/Al | ITO/BaytronP (approximately 65 nm)/polymer of Synthesis Example 3 (10 nm)/polymer of Comparative Example 1 (approximately 100 nm)/Ba/Al |
| Raw material for light-emitting layer polymer | | |
| HPLC purity of F8BE | 100% | 99.8% |
| Content of impurity having retention time shorter than retention time of F8BE in F8BE | 0.09% | 0.16% |
| HPLC purity of F6BE | 99.9% | 99.9% |
| Content of impurity having retention time shorter than retention time of F6BE in F6BE | 0.04% | 0.23% |
| Luminance (cd/m²) @6 V | 1261 | 995 |
| Efficiency (cd/A) @ maximum value | 2.05 | 1.94 |
| Half lifetime (hrs) @ 3,000 cd/m² | 187.8 | 133.6 |
| Initial drive voltage (V) @ 3,000 cd/m² | 6.6 | 7.2 |

## Claims

1. A compound represented by Formula (1) or (2) below, wherein
a content of an impurity having a molecular weight larger than a molecular weight of the compound represented by Formula (1) or (2) is 0.15% or less; and
the content of the impurity is a percentage of a sum of peak areas having a retention time shorter than a retention time of a peak identified as Formula (1) or (2) in a chromatogram of an organic solvent-based size-exclusion chromatograph method relative to a sum of all peak areas:
[Chemical Formula 1]
Z¹-ArY¹-Z¹ (1)
where Ar^{Y1} represents an arylene group, a divalent heterocyclic group, or a divalent group in which at least one arylene group and at least one divalent heterocyclic group are directly bonded, and these groups may have a substituent; and Z¹ represents a leaving group, 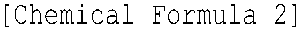 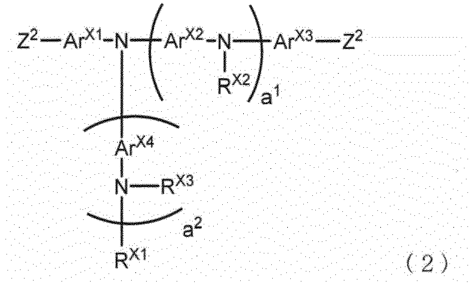 where a¹ and a² each independently represent an integer of 0 or more; Ar^{X1} and Ar^{X3} each independently represent an arylene group or a divalent heterocyclic group, and these groups may have a substituent; Ar^{X2} and Ar^{X4} each independently represent an arylene group, a divalent heterocyclic group, or a divalent group in which at least one arylene group and at least one divalent heterocyclic group are directly bonded, and these groups may have a substituent; R^{X1}, R^{X2}, and R^{X3} each independently represent a hydrogen atom, an alkyl group, an aryl group, or a monovalent heterocyclic group, and these groups may have a substituent; and Z² represents a leaving group.

2. The compound according to claim 1, wherein, in a chromatogram of high performance liquid chromatography using a reverse-phase column, a purity according to an area percentage method is more than 99%.

3. The compound according to claim 1 or 2, wherein the leaving group represented by Z¹ and Z² is a group selected from the group consisting of a substituent group A or a substituent group B below;
the substituent group A is a chlorine atom, a bromine atom, an iodine atom, and a group represented by -O-S(=O)₂R^{C1} where R^{C1} represents an alkyl group or an aryl group, and these groups may have a substituent; and
the substituent group B is a group represented by - B(OR^{C2})₂ where R^{C2} represents a hydrogen atom, an alkyl group, or an aryl group, these groups may have a substituent, and a plurality of R^{C2} may be the same or different and may be combined together to form a ring structure together with oxygen atoms to which they are bonded;
a group represented by -BF_{3Q}' where Q' represents Li, Na, K, Rb or Cs;
a group represented by -MgY' where Y' represents a chlorine atom, a bromine atom, or an iodine atom;
a group represented by -ZnY" where Y" represents a chlorine atom, a bromine atom, or an iodine atom; and
a group represented by -Sn(R^{C3})₃ where R^{C3} represents a hydrogen atom, an alkyl group, or an aryl group, these groups may have a substituent, and a plurality of R^{C3} may be the same or different and may be combined together to form a ring structure together with tin atoms to which they are bonded.

4. The compound according to any one of claims 1 to 3, wherein the leaving group represented by Z¹ and Z² is a bromine atom or a group represented by -B(OR^{C2})₂ where R^{C2} represents a hydrogen atom, an alkyl group, or an aryl group, these groups may have a substituent, and a plurality of R^{C2} may be the same or different and may be combined together to form a ring structure together with oxygen atoms to which they are bonded.

5. The compound according to any one of claims 1 to 4, which is used for synthesis of a compound by condensation reaction.

6. The compound according to claim 5, wherein the compound synthesized is an organic EL material.

7. The compound according to claim 5 or 6, wherein the compound synthesized is a polymer compound.

8. A method for producing a compound, the method comprising performing condensation reaction by using the compound represented by Formula (1) according to any one of claims 1 to 4, and the compound represented by Formula (2) according to any one of claims 1 to 4.

9. A method for producing a compound, the method comprising performing condensation reaction by using the compound represented by Formula (1) according to any one of claims 1 to 4, the compound represented by Formula (2) according to any one of claims 1 to 4, and a compound represent by Formula (3) below;
[Chemical Formula 3]
R^{X4}-Z³ (3)
where R^{X4} represents an aryl group or a monovalent heterocyclic group, and these groups may have a substituent; and Z³ represents a leaving group.

10. The method for producing a compound according to claim 8 or 9, wherein the compound produced is an organic EL material.

11. The method for producing a compound according to any one of claims 8 to 10, wherein the compound produced is a polymer compound.

12. A method for purifying a compound represented by Formula (1) or (2):
[Chemical Formula 4]
Z¹-Ar^{Y1}-Z¹ (1)
where Ar^{Y1} represents an arylene group, a divalent heterocyclic group, or a divalent group in which at least one arylene group and at least one divalent heterocyclic group are directly bonded, and these groups may have a substituent; and Z¹ represents a leaving group, 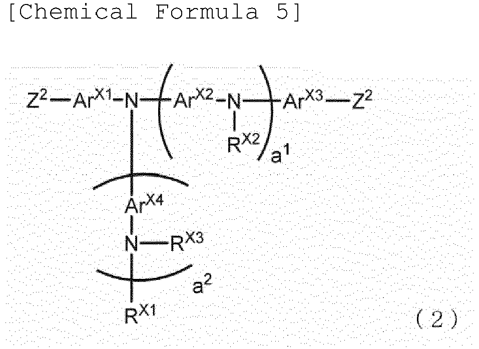 where a¹ and a² each independently represent an integer of 0 or more; Ar^{X1} and Ar^{X3} each independently represent an arylene group or a divalent heterocyclic group, and these groups may have a substituent; Ar^{X2} and Ar^{X4} each independently represent an arylene group, a divalent heterocyclic group, or a divalent group in which at least one arylene group and at least one divalent heterocyclic group are directly bonded, and these groups may have a substituent; R^{X1}, R^{X2}, and R^{X3} each independently represent a hydrogen atom, an alkyl group, an aryl group, or a monovalent heterocyclic group, and these groups may have a substituent; and Z² represents a leaving group,
the method comprising dissolving the compound represented by Formula (1) or (2) in a solvent and then bringing the compound represented by Formula (1) or (2) into contact with activated carbon to reduce a content of an impurity having a molecular weight larger than a molecular weight of the compound represented by Formula (1) or (2) to 0.15% or less, wherein
the content of the impurity is a percentage of a sum of peak areas having a retention time shorter than a retention time of a peak identified as Formula (1) or (2) in a chromatogram of organic solvent-based size-exclusion chromatography relative to a sum of all peak areas.

13. An organic EL material comprising a polymer formed by condensation polymerization of the compound represented by Formula (1) according to any one of claims 1 to 4 and the compound represented by Formula (2) according to any one of claims 1 to 4.

14. An organic EL material comprising a polymer formed by condensation polymerization of the compound represented by Formula (1) according to any one of claims 1 to 4, the compound represented by Formula (2) according to any one of claims 1 to 4, and the compound represented by Formula (3).

15. A composition comprising the organic EL material according to claim 13 or 14, and an organic solvent.

16. A thin film comprising the organic EL material according to claim 13 or 14.

17. An organic EL element comprising the thin film according to claim 16.
